(19) Europäisches Patentamt
European Patent Office
Office européen des brevets

(11) Veröffentlichungsnummer : **0 138 754 B1**

(12) **EUROPÄISCHE PATENTSCHRIFT**

(45) Veröffentlichungstag der Patentschrift : **25.05.88**

(51) Int. Cl.⁴ : **C 08 F 2/50**, G 03 C 1/68

(21) Anmeldenummer : **84810392.5**

(22) Anmeldetag : **09.08.84**

(54) **Photohärtbare Gemische.**

(30) Priorität : **15.08.83 CH 4430/83**
**29.08.83 CH 4722/83**

(43) Veröffentlichungstag der Anmeldung : **24.04.85 Patentblatt 85/17**

(45) Bekanntmachung des Hinweises auf die Patenterteilung : **25.05.88 Patentblatt 88/21**

(84) Benannte Vertragsstaaten :
**BE DE FR GB IT NL SE**

(56) Entgegenhaltungen :
**EP-A- 0 003 002**
**EP-A- 0 007 468**
**EP-A- 0 088 050**
**Die Akte enthält technische Angaben, die nach dem Eingang der Anmeldung eingereicht wurden und die nicht in dieser Patentschrift enthalten sind.**

(73) Patentinhaber : **CIBA-GEIGY AG**
**Klybeckstrasse 141**
**CH-4002 Basel (CH)**

(72) Erfinder : **Berner, Godwin, Dr.**
**Waldhofstrasse 70**
**CH-4310 Rheinfelden (CH)**
Erfinder : **Meier, Kurt, Dr.**
**Ulmenstrasse 11**
**CH-4123 Allschwil (CH)**
Erfinder : **Dietliker, Kurt, Dr.**
**Ave Jean-Marie Musy 6**
**CH-1700 Fribourg (CH)**
Erfinder : **Hüsler, Rinaldo, Dr.**
**Route de Mgr-Besson 6**
**CH-1700 Fribourg (CH)**

**EP 0 138 754 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die Erfindung betrifft photohärtbare Gemische auf der Grundlage von ethylenisch ungesättigten photopolymerisierbaren Verbindungen und einer synergistischen Kombination eines spezifischen Photoinitiators und eines Photosensibilisators.

Photoinitiatoren für radikalisch polymerisierbare Verbindungen sind Verbindungen, die bei Bestrahlung mit kurzwelligem Licht in radikalische Bruchstücke zerfallen, welche die eigentlichen Initiatoren für die Polymerisation der ethylenisch ungesättigten Verbindung sind. Beispiele für bekannte Photoinitiatoren sind vor allem aromatische Carbonylverbindungen wie z. B. Benzil, Benzoin, Benzoinether, Benzilmonoketale, α-Halogenacetophenone oder α-Alkoxyacetophenone. Aus der US-PS 4 017 652 ist bekannt, dass man die Aktivität solcher aromatischer Carbonyl-Photoinitiatoren erheblich steigern kann, wenn man als Co-Katalysator eine aromatische Carbonylverbindung zusetzt, die bei Bestrahlung in einen angeregten Zustand (Triplett-Zustand) übergehen kann, ohne dass sie sich in Radikale spaltet. Diese-Co-Katalysatoren, die man auch Photosensibilisatoren nennt, sind in der Lage, ihre Energie auf den Photoinitiator zu übertragen, wenn ihre Triplettenergie in einem richtigen Bereich liegt. Vorgeschlagen wird die Verwendung von aromatischen Carbonylverbindungen mit einer Triplett-Energie von etwa 54-72 kcal/mol (225-300 kJ/mol), insbesondere von Benzophenon.

Eine relativ neue Klasse von Photoinitiatoren sind Aryl-sec.-alkylketone, welche in der α-Stellung durch eine Sauerstoff- oder Aminfunktion substituiert sind und durch die allgemeine Formel

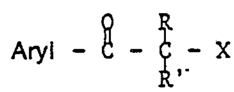

wiedergegeben werden können, wobei R und R′ organische Reste, vorzugsweise Alkylreste, sind und X a) eine freie, veretherte, veresterte oder silylierte Hydroxylgruppe oder b) eine Aminogruppe sein kann. Solche Verbindungen und ihre Verwendung als Photoinitiatoren sind in der EP-A-3002 sowie in der DE-OS 2 722 264 beschrieben. Hierbei sind die Verbindungen vom Typ a) im allgemeinen wesentlich reaktiver als die Verbindungen vom Typ b). Man kann für beide Typen eine Wirkungssteigerung durch Zusatz von Sensibilisatoren erzielen. So ist die Kombination des Typs a) mit 2-Alkylthioxanthonen in der DE-OS 3 010 148 als wirkungssteigernd beschrieben. In den älteren europäischen Anmeldungen EP-A-88050 und EP-A-117 233 ist beschrieben, dass sich gewisse Verbindungen vom Typ b) sensibilisieren lassen, beispielsweise durch organische Farbstoffe, Perylen oder Derivate des Anthracens oder Thioxanthons. Es wurde nun gefunden, dass sich weitere Verbindungen vom Typ b) mit aromatischen Carbonylverbindungen sensibilisieren lassen, die eine Triplettenergie von 225-310 kJ/mol besitzen. Dies führt in vielen Fällen zu einer Umkehr der oben erwähnten Wirksamkeitsabstufung. Während z. B. eine Verbindung mit X = OH allein im allgemeinen aktiver ist als ihr Analogon mit X = —$N(CH_3)_2$, ist im Gemisch mit einem solchen Sensibilisator die Aminoverbindung der Hydroxylverbindung überlegen.

Die Erfindung betrifft daher photopolymerisierbare Gemische, enthaltend

A) mindestens eine ethylenisch ungesättigte photopolymerisierbare Verbindung,

B) mindestens einen Photoinitiator der Formel I oder II

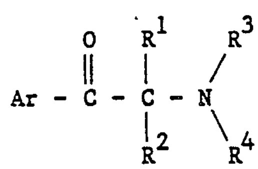

(I)

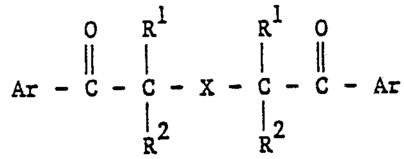

(II)

worin Ar eine unsubstituierte oder durch einen oder mehrere der Reste Halogen, $C_1$-$C_{12}$-Alkyl, $C_3$-$C_{12}$-Alkenyl, $C_5$-$C_6$-Cycloalkyl, $C_7$-$C_9$-Phenylalkyl, —COOH, —COO($C_1$-$C_4$-Alkyl), —$OR^5$, Methylendioxy, —SH, —$SR^6$, —SO-$R^6$, —$SO_2$-$R^6$, —CN, —$SO_2NH_2$, —$SO_2NH$($C_1$-$C_4$-Alkyl), —$SO_2$-N($C_1$-$C_4$-Alkyl$)_2$, —$N(R^7)(R^8)$, —NHCO-$R^9$ oder durch eine Gruppe der Formel

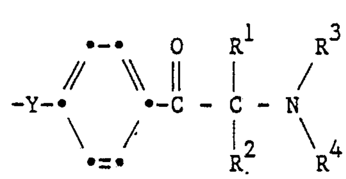

substituierte Phenyl-, Biphenylyl- oder Benzoylphenylgruppe oder eine Gruppe der Formeln III, IV oder V bedeutet,

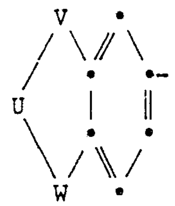 (III) 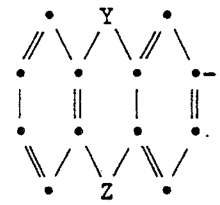 (IV)

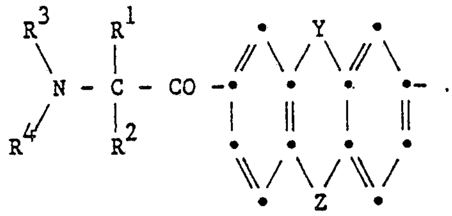 (V)

worin

U unverzweigtes oder verzweigtes $C_1$-$C_7$-Alkylen ist,

V eine direkte Bindung, —O—, —S— oder —N($R^{10}$)— bedeutet,

W eine direkte Bindung, —O—, —S— oder —N($R^{10}$)— bedeutet,

X einen zweiwertigen Rest der Formel

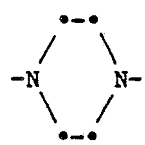,

—N($R^{11}$)— oder —N($R^{11}$)-$(CH_2)_m$-N($R^{11'}$)— mit m = 1-8 bedeutet,

Y eine direkte Bindung, —$CH_2$—, —$CH_2CH_2$—, —O—, —S—, —CO— oder —N($R^{10}$)— bedeutet,

Z eine direkte Bindung ist unter der Bedingung, dass Y nicht gleichzeitig eine direkte Bindung ist, oder —$CH_2$—, —$CH_2CH_2$—, —O—, —S—, —CO— oder —N($R^{10}$)— bedeutet,

$R^1$ und $R^2$ unabhängig voneinander $C_1$-$C_8$-Alkyl, durch OH, $C_1$-$C_4$-Alkoxy, —CN, —COO($C_1$-$C_8$-Alkyl), ($C_1$-$C_4$-Alkyl)-COO— oder —N($R^3$)($R^4$) substituiertes $C_1$-$C_4$-Alkyl, $C_3$-$C_6$-Alkenyl, Phenyl, Chlorphenyl, $R^5$-O-Phenyl, $R^6$-S-Phenyl oder $C_7$-$C_9$-Phenylalkyl bedeuten, oder $R^1$ und $R^2$ zusammen unverzweigtes oder verzweigtes $C_2$-$C_9$-Alkylen oder $C_3$-$C_9$-Oxa- oder Azaalkylen bedeuten,

$R^3$ und $R^4$ unabhängig voneinander Wasserstoff, $C_1$-$C_{12}$-Alkyl, durch eine oder mehrere der Gruppen OH, $C_1$-$C_4$-Alkoxy, —CN oder —COO($C_1$-$C_4$-Alkyl) substituiertes $C_2$-$C_4$-Alkyl, $C_3$-$C_5$-Alkenyl, Cyclohexyl, $C_7$-$C_9$-Phenylalkyl, Phenyl oder durch Cl, OH, $C_1$-$C_{12}$-Alkyl, $C_1$-$C_4$-Alkoxy oder —COO($C_1$-$C_4$-Alkyl) substituiertes Phenyl bedeuten oder $R^3$ und $R^4$ zusammen $C_3$-$C_7$-Alkylen bedeuten, das durch —O—, —S— oder —N($R^{12}$)— unterbrochen sein kann, oder $R^4$ zusammen mit $R^2$ $C_1$-$C_7$-Alkylen, $C_7$-$C_{10}$-Phenylalkylen, o-Xylylen oder $C_1$-$C_3$-Oxa- oder Azaalkylen bedeutet,

$R^5$ Wasserstoff, $C_1$-$C_{12}$-Alkyl, $C_3$-$C_{12}$-Alkenyl, Cyclohexyl, Hydroxycyclohexyl, durch einen oder mehrere der Reste Cl, Br, CN, SH, —N($C_1$-$C_4$-Alkyl)$_2$, Piperidino, Morpholino, OH, —O($C_1$-$C_4$-Alkyl), —$OCH_2CH_2CN$, —$OCH_2CH_2COO$($C_1$-$C_4$-Alkyl), —OOC-$R^9$, —COOH, —COO($C_1$-$C_8$-Alkyl), —CONH($C_1$-$C_4$-Alkyl), —CON($C_1$-$C_4$-Alkyl)$_2$,

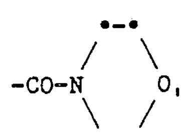,

—CO-($C_1$-$C_4$-Alkyl) oder —CO-Phenyl substituiertes $C_1$-$C_4$-Alkyl, 2,3-Epoxypropyl, —$(CH_2CH_2O)_n$-H mit n = 2-20, Phenyl, $C_7$-$C_9$-Phenylalkyl, durch Halogen, $C_1$-$C_4$-Alkyl, $C_1$-$C_4$-Alkoxy oder —COO($C_1$-$C_4$-Alkyl) substituiertes Phenyl, Tetrahydropyranyl, Tetrahydrofuranyl, eine Gruppe —CO-$R^9$, —COO($C_1$-$C_8$-Alkyl), —CONH($C_1$-$C_4$-Alkyl), —CON($C_1$-$C_4$-Alkyl)$_2$, —Si($R^{13}$)($R^{14}$)$_2$ oder —$SO_2$-$R^{15}$ bedeutet.

$R^6$ $C_1$-$C_{12}$-Alkyl, $C_3$-$C_{12}$-Alkenyl, Cyclohexyl, Hydroxycyclohexyl, durch eine oder mehrere der Gruppen Cl, Br, CN, SH, —N($C_1$-$C_4$-Alkyl)$_2$, Piperidino, Morpholino, —OH, —O($C_1$-$C_4$-Alkyl), —$OCH_2CH_2$-CN, —$OCH_2CH_2COO$($C_1$-$C_4$-Alkyl), —OOC-$R^9$, —COOH, —COO($C_1$-$C_8$-Alkyl), —CON($C_1$-$C_8$-Alkyl)$_2$,

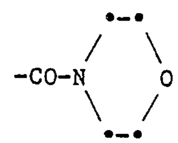

—CO-($C_1$-$C_4$-Alkyl) oder —CO-Phenyl substituiertes $C_1$-$C_4$-Alkyl, 2,3-Epoxypropyl, Phenyl, $C_7$-$C_9$-Phenylalkyl, $C_7$-$C_9$-Phenylhydroxyalkyl, durch Halogen, $C_1$-$C_4$-Alkyl, $C_1$-$C_4$-Alkoxy oder —COO($C_1$-$C_4$-Alkyl) substituiertes Phenyl, 2-Benzthiazolyl, 2-Benzimidazolyl, —$CH_2CH_2$-O-$CH_2CH_2$-SH oder —$CH_2CH_2$-S-$CH_2CH_2$-SH bedeutet,

$R^7$ und $R^8$ unabhängig voneinander Wasserstoff, $C_1$-$C_{12}$-Alkyl, durch eine Gruppe —OH, $C_1$-$C_4$-Alkoxy, —CN oder —COO($C_1$-$C_4$-Alkyl) substituiertes $C_2$-$C_4$-Alkyl, $C_3$-$C_5$-Alkenyl, Cyclohexyl, $C_7$-$C_9$-Phenylalkyl, Phenyl oder durch eine oder mehrere der Gruppen $C_1$-$C_{12}$-Alkyl oder Halogen substituiertes Phenyl bedeuten, oder $R^7$ und $R^8$ zusammen $C_2$-$C_7$-Alkylen bedeuten, das durch —O—, —S— oder —N($R^{12}$)- unterbrochen sein kann,

$R^9$ $C_1$-$C_4$-Alkyl, $C_2$-$C_4$-Alkenyl oder Phenyl bedeutet,

$R^{10}$ Wasserstoff, $C_1$-$C_4$-Alkyl, Allyl, Benzyl oder $C_1$-$C_4$-Hydroxalkyl bedeutet,

$R^{11}$ und $R^{11'}$ Wasserstoff, $C_1$-$C_9$-Alkyl, $C_1$-$C_4$-Hydroxyalkyl, Cyclohexyl oder Benzyl bedeuten,

$R^{12}$ Wasserstoff, $C_1$-$C_4$-Alkyl, Allyl, Benzyl, $C_1$-$C_4$-Hydroxyalkyl, —$CH_2CH_2CN$ oder —$CH_2CH_2$—COO($C_1$-$C_4$-Alkyl) bedeutet,

$R^{13}$ und $R^{14}$ $C_1$-$C_4$-Alkyl oder Phenyl bedeuten und

$R^{15}$ $C_1$-$C_{18}$-Alkyl, Phenyl oder $C_7$-$C_{20}$-Alkylphenyl bedeutet, und

C) einen Photosensibilisator aus der Gruppe der aromatischen Carbonylverbindungen mit einer Triplettenergie von 225-310 kJ/mol, wobei im Fall, dass B eine Verbindung der Formel I oder II ist, in der Ar einen Schwefel oder Sauerstoff enthaltenden aromatischen Rest bedeutet, C kein Thioxanthonderivat ist.

Die Komponente A) kann aus einer oder mehreren ungesättigten Verbindungen bestehen. Vorzugsweise enthält das Gemisch zwei oder drei ungesättigte photopolymerisierbare Verbindungen. Die ungesättigten Verbindungen können eine oder mehrere olefinische Doppelbindungen enthalten. Sie können niedermolekular (monomer) oder höhermolekular (oligomer) sein. Beispiele für Monomere mit einer Doppelbindung sind Alkyl- oder Hydroxyalkyl-acrylate oder -methacrylate, wie z. B. Methyl-, Ethyl-, Butyl-, 2-Ethylhexyl- oder 2-Hydroxyethylacrylat, Isobornylacrylat, Methyl- oder Ethylmethacrylat. Weitere Beispiele hierfür sind Acrylnitril, Acrylamid, Methacrylamid, N-substituierte (Meth)acrylamide, Vinylester wie Vinylacetat, Vinylether wie Isobutylvinylether, Styrol, Alkyl- und Halogenstyrole, N-Vinylpyrrolidon, Vinylchlorid oder Vinylidenchlorid.

Beispiele für Monomere mit mehreren Doppelbindungen sind Ethylenglykol-, Propylenglykol-, Neopentylglykol-, Hexamethylenglykol-, oder Bisphenol-A-diacrylat, 4,4'-Bis(2-acryloyloxyethoxy)-diphenylpropan, Trimethylolpropan-triacrylat, Pentaerythrit-triacrylat oder -tetraacrylat, Vinylacrylat, Divinylbenzol, Divinylsuccinat, Diallylphthalat, Triallylphosphat, Triallylisocyanurat oder Tris-(2-acryloyloxyethyl) isocyanurat.

Beispiele für höhermolekulare (oligomere) mehrfach ungesättigte Verbindungen sind acrylierte Epoxidharze, acrylierte Polyether, acrylierte Polyurethane oder acrylierte Polyester. Weitere Beispiele für ungesättigte Oligomere sind ungesättigte Polyesterharze, die meist aus Maleinsäure, Phthalsäure und einem oder mehreren Diolen hergestellt werden und Molekulargewichte von etwa 500 bis 3000 besitzen. Solche ungesättigte Oligomere kann man auch als Prepolymere bezeichnen.

Häufig verwendet man Zweikomponenten-Gemische eines Prepolymeren mit einem mehrfach ungesättigten Monomeren oder Dreikomponentengemische, die ausserdem noch ein einfach ungesättigtes Monomer enthalten. Das Prepolymere ist hierbei in erster Linie für die Eigenschaften des Lackfilmes massgebend, durch seine Variation kann der Fachmann die Eigenschaften des gehärteten Filmes beeinflussen. Das mehrfach ungesättigte Monomere fungiert als Vernetzer, das den Lackfilm unlöslich macht. Das einfach ungesättigte Monomere fungiert als reaktiver Verdünner, mit dessen Hilfe die Viskosität herabgesetzt wird, ohne dass man ein Lösungsmittel verwenden muss.

Solche Zwei- und Dreikomponentensysteme auf der Basis eines Prepolymeren werden sowohl für Druckfarben als auch für Lacke, Photoresists oder andere photohärtbare Massen verwendet. Als Bindemittel für Druckfarben werden vielfach auch Einkomponenten-Systeme auf der Basis photohärtbarer Prepolymerer verwendet.

Ungesättigte Polyesterharze werden meist in Zweikomponentensystemen zusammen mit einem einfach ungesättigten Monomer, vorzugsweise mit Styrol, verwendet. Für Photoresists werden oft spezifische Einkomponentensysteme verwendet, wie z. B. Polymaleinimide, Polychalkone oder Polyimide, wie sie in der DE-OS 2 308 830 beschrieben sind.

Das Gemisch kann ausserdem nicht-photopolymerisierbare filmbildende Komponenten enthalten.

Diese können z. B. physikalisch trocknende Polymere bzw. deren Lösungen in organischen Lösungsmitteln sein, wie z. B. Nitrocellulose oder Celluloseacetobutyrat. Diese können aber auch chemisch bzw. thermisch härtbare Harze sein, wie z. B. Polyisocyanate, Polyepoxide oder Melaminharze. Die Mitverwendung von thermisch härtbaren Harzen ist für die Verwendung in sogenannten Hybrid-Systemen von Bedeutung, die in einer ersten Stufe photopolymerisiert werden und in einer zweiten Stufe durch thermische Nachbehandlung vernetzt werden.

Weiterhin können die Gemische auch Synthesekautschuke enthalten. Soweit diese ethylenisch ungesättigte Bindungen enthalten, können sie an der Photopolymerisation teilnehmen. Solche Gemische sind für die Herstellung elastischer Druckplatten von Bedeutung.

Das Gemisch enthält als Photoinitiator mindestens ein Aminoketon der Formel I oder II, wie sie vorstehend definiert wurden. Hierbei kann $R^1$ und $R^2$ $C_1$-$C_8$-Alkyl sein wie z. B. Methyl, Ethyl, Propyl, Isopropyl, n-Butyl, iso-Butyl, n-Pentyl, iso-Pentyl, n-Hexyl, 2-Ethylbutyl, n-Heptyl oder n-Octyl. $R^1$ und $R^2$ als substituiertes Alkyl kann z. B. Hydroxymethyl, 2-Hydroxyethyl, 2-Methoxyethyl, 2-Ethoxybutyl, 2-Cyanoethyl, Ethoxycarbonylmethyl, 2-Methoxycarbonylethyl, 2-Butoxycarbonylisopropyl, 2-Acetoxyethyl, 2-Butyroyloxypropyl, 2-Dimethylaminoethyl, 3-Diethylaminopropyl oder 2-Di(2-hydroxyethyl)aminoethyl sein. $R^1$ und $R^2$ als $C_3$-$C_6$-Alkenyl sind insbesondere Alkenylmethyl wie z. B. Allyl, Methallyl, Ethallyl oder 2-Butenyl · $R^1$ und $R^2$ als $R^5$O-Phenyl oder $R^6$S-Phenyl .kann z. B. 3-Methoxyphenyl, 4-Hydroxyphenyl, 4-Mercaptophenyl oder 4-tert.-Butylmercaptophenyl sein.

Wenn $R^1$ und $R^2$ zusammen Alkylen, Oxa- oder Azaalkylen bedeuten, so bilden sie zusammen mit dem C-Atom, an das sie gebunden sind, einen gesättigten Ring, wie z. B. einen Cyclopropan-, Cyclopentan-, Cyclohexan-, Cyclooctan-, 3-Methylcyclohexan-, 4-Ethylcyclohexan-, Tetrahydropyran-, Tetrahydrofuran-, Pyrrolidin-, Piperidin- oder 2-Ethylpiperidinring.

$R^3$ und $R^4$ als Alkyl sind z. B. Methyl, Ethyl, Propyl, iso-Propyl, Butyl, Hexyl, Octyl oder Dodecyl. $R^3$ und $R^4$ als substituiertes Alkyl sind z.. B. 2-Hydroxyethyl, 2-Hydroxypropyl, 2-Methoxyethyl, 3-Butoxypropyl, 2-Cyanoethyl, Ethoxycarbonylmethyl oder 2-Methoxycarbonylethyl.

$R^3$ und $R^4$ als Alkenyl sind insbesondere Alkenylmethyl wie z. B. Allyl, Methallyl, Ethallyl oder 2-Butenyl. $R^3$ und $R^4$ als Phenylalkyl können z. B. Benzyl, Phenylethyl oder Phenylpropyl sein. Wenn $R^3$ und $R^4$ zusammen Alkylen oder durch ein Heteroatom unterbrochenes Alkylen bedeuten, so bilden sie zusammen mit dem N-Atom einen Ring, wie z. B. einen Pyrrolidin-, Methylpyrrolidin-, Piperidin-, Ethylpiperidin-, Dimethylpiperidin-, Morpholin-, Thiomorpholin-, Piperazin-, 4-Methylpiperazin oder 4-(Cyanethyl)piperazinring.

Wenn $R^4$ zusammen mit $R^2$ Alkylen, Phenylalkylen, o-Xylylen, Oxa- oder Azaalkylen bedeuten, so bilden diese zusammen mit dem N-Atom und dem C-Atom, an das sie gebunden sind, einen Ring, wie z. B. einen Pyrrolidin-, Piperidin-, Oxazolidin-, Morpholin-, Imidazolidin- oder Piperazinring, der durch Alkyl oder Phenyl substituiert oder durch einen Benzoerest anneliert sein kann.

$R^5$ und $R^6$ als $C_1$-$C_{12}$-Alkyl können einer der für $R^3$ und $R^4$ genannten unverzweigten oder verzweigten Alkylreste sein. $R^5$ und $R^6$ als $C_3$-$C_{12}$-Alkenyl sind insbesondere Alkenylmethyl wie z. B. Allyl, Methallyl, 2-Butenyl, 2-Pentenyl, 3-Methyl-2-butenyl oder 2-Heptenyl. $R^5$ und $R^6$ als substituiertes Alkyl können z. B.' 2-Chlorethyl, 2-Brompropyl, 2-Cyanoethyl, 2-Mercaptopropyl, 3-(Dimethylamino)-propyl, 2-Morpholinobutyl, 2-Hydroxyethyl, 2,3-Dihydroxypropyl, 2-Hydroxybutyl, 2-Methoxypropyl, 2-Ethoxyethyl, 2-(2-Cyanoethoxy)-ethyl, 2-(2-Methoxycarbonylethoxy)-ethyl, 2-Acetoxypropyl, 2-Propionyloxyethyl, 2-Methoxycarbonyl-ethyl, 2-Butoxycarbonyl-propyl, Ethoxycarbonylmethyl, 2-(Dimethylaminocarbonyl)-ethyl, 2-Morpholinocarbonylpropyl, 2-Acetylethyl oder Benzoylmethyl sein. $R^5$ und $R^6$ als substituiertes Phenyl kann z. B. 4-Chlorphenyl, 3-Bromphenyl, 4-Tolyl, 4-tert.-Butylphenyl, 3-Methoxyphenyl, 2-Chlor-4-methylphenyl, 3-Methoxy-5-chlorphenyl, 4-Butoxycarbonyl-phenyl oder 3-Methoxycarbonyl-phenyl sein. $R^5$ und $R^6$ als Phenylalkyl können z. B. Benzyl, 1-Phenylethyl, 2-Phenylethyl oder 1-Phenylisopropyl sein.

$R^9$, $R^{10}$, $R^{12}$, $R^{13}$ und $R^{14}$ als $C_1$-$C_4$-Alkyl können Methyl, Ethyl, n-Propyl, iso-Propyl, n-Butyl, sec-Butyl, iso-Butyl oder tert-Butyl sein. $R^9$ als $C_2$-$C_4$-Alkenyl kann z. B. Vinyl, Isopropenyl oder 1-Propenyl sein.

$R^7$ und $R^8$ als Alkyl können z. B. Methyl, Ethyl, Propyl, iso-Propyl, Butyl, Hexyl, Octyl oder Dodecyl sein. Als substituiertes Alkyl können $R^7$ und $R^8$ beispielsweise 2-Hydroxyethyl, 2-Hydroxypropyl, 2-Methoxyethyl, 2-Cyanoethyl oder 2-Methoxycarbonylethyl sein. $R^7$ und $R^8$ als Alkenyl sind insbesondere Allyl. $R^7$ und $R^8$ als Phenylalkyl sind insbesondere Benzyl oder Phenylethyl.

Wenn $R^7$ und $R^8$ zusammen Alkylen oder durch ein Heteroatom unterbrochenes Alkylen darstellen, so bilden sie zusammen mit dem N-Atom einen heterocyclischen Ring, wie z. B. einen Pyrrolidin-, Piperidin-, Morpholin-, 2,6-Dimethylmorpholin-, Piperazin-, 4-Methylpiperazin- oder 4-(Cyanethyl)-piperazinring.

$R^{11}$ und $R^{11'}$ als $C_1$-$C_9$-Alkyl können einer der für $R^9$ aufgeführten Reste sein und darüber hinaus auch unverzweigtes oder verzweigtes Pentyl, Hexyl, Heptyl, Octyl oder Nonyl. $R^{15}$ als Alkyl kann darüber hinaus auch z. B. Decyl, Dodecyl, Hexadecyl oder Octadecyl sein.

$R^{10}$, $R^{11}$, $R^{11'}$ und $R^{12}$ als Hydroxyalkyl können z. B. Hydroxymethyl, 2-Hydroxyethyl, 2-Hydroxybutyl oder 3-Hydroxypropyl sein.

$R^{15}$ als $C_7$-$C_{20}$-Alkylphenyl kann z. B. 4-Tolyl, 4-Hexylphenyl, 4-Dodecylphenyl, Nonylnaphthyl oder Dibutylphenyl sein.

Vorzugsweise enthält das photopolymerisierbare Gemisch als Komponente B) einen Photoinitiator

der Formel I oder II, worin Ar eine unsubstituierte oder durch einen oder mehrere der Reste Halogen, $C_1$-$C_{12}$-Alkyl, $C_3$-$C_{12}$-Alkenyl, $C_5$-$C_6$-Cycloalkyl, $C_7$-$C_9$-Phenylalkyl, —COOH, —COO($C_1$-$C_4$-Alkyl), —$SO_2$-$R^6$, —CN, —$SO_2NH_2$, —$SO_2NH$($C_1$-$C_4$-Alkyl), —$SO_2$-N($C_1$-$C_4$-Alkyl$)_2$, —N($R^7$)($R^8$), —NHCO-$R^9$ oder durch eine Gruppe der Formel

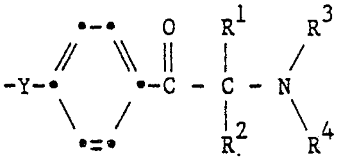

substituierte Phenyl-, Biphenylyl- oder Benzoylphenylgruppe bedeutet, Y eine direkte Bindung, —$CH_2$—, —$CH_2CH_2$—, —CO— oder —N($R^{10}$)— bedeutet und X, $R^1$, $R^2$, $R^3$, $R^4$, $R^6$, $R^7$, $R^8$, $R^9$ und $R^{10}$ die oben angegebene Bedeutung haben.

Bevorzugt sind weiterhin Gemische, die als Komponente B) einen Photoinitiator der Formel I oder II enthalten, worin Ar eine unsubstituierte oder durch Chlor, $C_1$-$C_4$-Alkyl, Methylendioxy, —$OR^5$, —$SR^6$, —N($R^7$)($R^8$) oder durch eine Gruppe der Formel

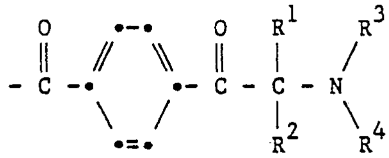

substituierte Phenyl- oder 4-Benzoylphenylgruppe bedeutet, X einen Rest der Formel

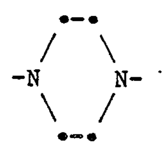

bedeutet, $R^1$ und $R^2$ unabhängig voneinander $C_1$-$C_4$-Alkyl, —$CH_2CH_2COO$($C_1$-$C_4$-Alkyl), Allyl oder Benzyl bedeuten oder $R^1$ und $R^2$ zusammen unverzweigtes $C_4$-$C_5$-Alkylen bedeuten, $R^3$ und $R^4$ unabhängig voneinander $C_1$-$C_{12}$-Alkyl, durch OH, $C_1$-$C_4$-Alkoxy, CN oder —COO($C_1$-$C_4$-Alkyl) substituiertes $C_2$-$C_4$-Alkyl, Allyl, Cyclohexyl oder Benzyl bedeuten, oder $R^3$ und $R^4$ zusammen $C_4$-$C_6$-Alkylen bedeuten, das durch —O— oder —N($R^{12}$)— unterbrochen sein kann, $R^5$ $C_1$-$C_4$-Alkyl, 2-Hydroxyethyl, 2,3-Epoxypropyl, Phenyl oder Benzyl bedeutet, $R^6$ $C_1$-$C_{12}$-Alkyl, Allyl, Cyclohexyl, durch OH, —COO($C_1$-$C_8$-Alkyl) oder —N($CH_3$$)_2$ substituiertes $C_1$-$C_4$-Alkyl, Benzyl, Phenyl, p-Tolyl oder —$CH_2CH_2OCH_2CH_2SH$ bedeutet, $R^7$ und $R^8$ unabhängig voneinander $C_1$-$C_4$-Alkyl, durch —OH, $C_1$-$C_4$-Alkoxy, —CN oder —COO($C_1$-$C_4$-Alkyl) substituiertes $C_2$-$C_4$-Alkyl, Cyclohexyl oder Allyl bedeuten oder $R^7$ und $R^8$ zusammen $C_4$-$C_6$-Alkylen bedeuten, das durch —O— oder —N($R^{12}$)— unterbrochen sein kann, und $R^{12}$ Wasserstoff, $C_1$-$C_4$-Alkyl oder $C_2$-$C_4$-Hydroxyalkyl bedeutet, insbesondere solche, die einen Photoinitiator der Formel I enthalten, worin Ar einen unsubstituierten oder in 4-Stellung durch Chlor, Methyl, Methoxy, Methylthio, Dialkylamino oder Morpholino substituierten Phenylrest, $R^1$ und $R^2$ $C_1$-$C_4$-Alkyl und $R^3$ und $R^4$ $C_1$-$C_4$-Alkyl oder 2-Methoxyethyl oder $R^3$ und $R^4$ zusammen mit dem N-Atom Morpholin bedeuten.

Beispiele für einzelne Verbindungen der Formel I sind die folgenden Verbindungen :

1-[4-(2-Hydroxyethylthio) phenyl]-2-methyl-2-morpholino-propanon-1
2-Methyl-1-[4-(methylthio) phenyl]-2-morpholino-propanon-1
1-(4-Mercaptophenyl)-2-methyl-2-morpholino-propanon-1
1-(4-Allylthiophenyl)-2-methyl-2-morpholino-propanon-1
1-[4-(2-Methoxycarbonylethylthio)-phenyl]-2-methyl-2-morpholino-propanon-1
1-[4-(Dimethylaminomethylthio)-phenyl]-2-morpholino-propanon-1
2-Methyl-1-[4-(methylsulfinyl)-phenyl]-2-morpholino-propanon-1
2-Methyl-1-[4-(methylthio)-phenyl]-2-piperidino-propanon-1
2-Methyl-1-[4-(methylthio)-phenyl]-2-(4-methylpiperazino)-propanon-1
2-Methyl-1-[4-(methylthio)-phenyl]-2-pyrrolidino-propanon-1
2-Methyl-1-[4-(methylthio)-phenyl]-2-di(2-methoxyethyl) amino-propanon-1
2-Methyl-1-[4-(methylthio)-phenyl]-2-dibutylamino-propanon-1
2-Methyl-1-[4-(phenylthio)-phenyl]-2-dibutylamino-propanon-1
2-Methyl-1-[4-(phenylthio)-phenyl]-2-piperidino-propanon-1
2-Methyl-1-[4-(butylthio)-phenyl]-2-morpholino-propanon-1

2-Methyl-1-[4-(phenylthio)-phenyl]-2-(4-methylpiperazino)-propanon-1
2-Methyl-1-[4-(phenylthio)-phenyl]-2-di(2-methoxyethyl) amino-propanon-1
2-Methyl-1-[4-(phenylthio)-phenyl]-2-morpholino-propanon-1
2-Methyl-1-[4-(ethylthio)-phenyl]-2-morpholino-propanon-1
2-Methyl-1-[4-(octylthio)-phenyl]-2-morpholino-propanon-1
2-Ethyl-1-[4-(methylthio)-phenyl]-3-morpholino-butanon-1
2-Methyl-1-[4-{2-(2-mercaptoethoxy)-ethylthio}-phenyl]-2-morpholino-propanon-1
2-Methyl-1-[4-(octyloxycarbonylmethylthio)-phenyl]-2-morpholino-propanon-1
2-Methyl-1-(2-thianthrenyl)-2-morpholino-propanon-1
1-[4-(Methylthio)-benzoyl]-1-morpholino-cyclohexan
2-Methyl-1-[4-(methylthio)-phenyl]-2-dimethylamino-propanon-1
2-Methyl-1-[4-(benzylthio)-phenyl]-2-morpholino-propanon-1
2-Methyl-1-[4-(4-methylphenylthio)-phenyl]-2-morpholino-propanon-1
2-Methyl-1-[4-(methylthio)-phenyl]-2-butylamino-propanon-1
2-Methyl-1-[4-(methylsulfinyl)-phenyl]-2-di(2-methoxyethyl) amino-propanon-1
2-Methyl-1-[4-(cyclohexylthio)-phenyl]-2-morpholino-propanon-1
2-Methyl-1-(4-chlorphenyl)-2-morpholino-propanon-1
2-Methyl-1-(4-morpholinophenyl)-2-morpholino-propanon-1
2-Methyl-1-phenyl-2-morpholino-propanon-1
2-Methyl-1-phenyl-2-dimethylamino-propanon-1
2-Methyl-1-phenyl-2-diethylamino-propanon-1
2-Methyl-1-phenyl-2-piperazino-propanon-1
1-Benzoyl-1-dimethylamino-cyclohexan
2-(2-Thenoyl)-2-morpholino-propan
2-Methyl-1-(3,4-dimethylphenyl)-2-morpholino-propanon-1
2-Methyl-1-phenyl-2-piperidino-propanon-1
2-Methyl-1-(4-chlorphenyl)-2-piperidino-propanon-1
2-Methyl-1-(4-methylphenyl)-2-piperidino-propanon-1
2-Methyl-1-(4-methoxyphenyl)-2-piperidino-propanon-1
2-Methyl-1-(4-phenoxyphenyl)-2-piperidino-propanon-1
2-[2-(Methoxycarbonyl) ethyl]-1-phenyl-2-dimethylamino-propanon-1
2-Methyl-1-(4-methoxyphenyl)-2-diethylamino-propanon-1
2-Methyl-1-phenyl-2-(4-methylpiperazino)-propanon-1
2-Methyl-1-[4-(dimethylamino) phenyl]-2-dimethylamino-propanon-1
2-Methyl-1-(4-piperidinophenyl)-2-piperidino-propanon-1
2-Methyl-1-[4-(4-methylpiperazino) phenyl]-2-(4-methylpiperazino)-propanon-1
Bis-4,4'-(α-morpholino-isobutyroyl)-benzophenon
2-Methyl-1-(4-methoxyphenyl)-2-morpholino-propanon-1
2-Methyl-1-(4-phenoxyphenyl)-2-morpholino-propanon-1
2-Methyl-1-(3,4-dimethoxyphenyl)-2-isopropylamino-propanon-1
1-(4-Methoxybenzoyl)-1-methylamino-cyclopentan
3-(4-Anisoyl)-3-methyl-1,2,3,4-tetrahydro-isochinolin
3-(4-Anisoyl)-3-benzyl-1,2,3,4-tetrahydro-isochinolin
3-(3,4-Dimethoxybenzoyl)-3-methyl-1,2,3,4-tetrahydro-isochinolin
2-Methyl-1-[4-(2,3-epoxypropyloxy) phenyl]-2-morpholino-propanon-1
2-Methyl-1-[4-(2-hydroxyethoxy) phenyl]-2-morpholino-propanon-1
2-Methyl-1-(4-methoxyphenyl)-2-di(2-methoxyethyl) amino-propanon-1
2-Methyl-1-(4-methoxyphenyl)-2-pyrrolidino-propanon-1
2-Methyl-1-(4-methoxyphenyl)-2-(4-methylpiperazino)-propanon-1
2-Methyl-1-(4-methoxyphenyl)-2-dimethylamino-propanon-1
2-Methyl-1-(4-methoxyphenyl)-2-dibutylamino-propanon-1
2-Methyl-1-(4-methoxyphenyl)-2-methylphenylamino-propanon-1
2-Methyl-1-(4-methoxyphenyl)-2-oxazolidino-propanon-1
1-(1,3-Benzodioxol-5-yl)-2-methyl-2-morpholino-propanon-1
1-(1,3-Benzodioxol-5-yl)-2-methyl-2-di(2-methoxyethyl) amino-propanon-1
2-Ethyl-1-(4-methoxyphenyl)-2-morpholino-hexanon-1
1-(1,3-Benzodioxol-5-yl)-2-methyl-2-pyrrolidino-propanon-1
1-(1,3-Benzodioxol-5-yl)-2-ethyl-2-pyrrolidino-butanon-1
1-(1,3-Benzodioxol-5-yl)-2-methyl-2-pyrrolidino-pentanon-1
2-Methyl-1-(3,4-dimethoxyphenyl)-2-morpholino-propanon-1
2-Methyl-1-(3,4,5-trimethoxyphenyl)-2-morpholino-propanon-1
1-(Dibenzofuran-2-yl)-2-methyl-2-morpholino-propanon-1
4-(2-Morpholino-2-methyl-propanoyl)-benzophenon
4-[2-Di(2-methoxyethyl)-amino-2-methylpropanoyl]-benzophenon
4-(2-Piperidino-2-methyl-propanoyl)-benzophenon

4-[2-(4-Methylpiperazino)-2-methyl-propanoyl)-benzophenon
4-(2-Dimethylamino-2-methyl-propanoyl)-benzophenon
4-(2-Morpholino-2-methyl-propanoyl)-4'-morpholino-benzophenon
4-(2-Piperidino-2-methyl-propanoyl)-4'-piperidino-benzophenon
4-(2-Dimethylamino-2-methyl-propanoyl)-4'-dimethylamino-benzophenon
4-[2-(4-Methylpiperazino)-2-methyl-propanoyl]-4'-(4-methylpiperazino)-benzophenon
2-(2-Morpholino-2-methyl-propanoyl)-fluorenon
2-(2-Piperidino-2-methyl-propanoyl)-fluorenon
2-(2-Dimethylamino-2-methyl-propanoyl)-fluorenon
2,7-Bis-(2-morpholino-2-methyl-propanoyl)-fluorenon
2-(2-Morpholino-2-methyl-propanoyl)-xanthon
2-(2-Morpholino-2-methyl-propanoyl)-acridanon
2-(2-Morpholino-2-methyl-propanoyl)-N-methyl-acridanon
2-(2-Morpholino-2-methyl-propanoyl)-dibenzosuberon
2-(2-Piperidino-2-methyl-propanoyl)-dibenzosuberon
2,7-Bis-(2-morpholino-2-methyl-propanoyl)-dibenzosuberon
2-(2-Morpholino-2-methyl-propanoyl)-thioxanthon
2-(2-Morpholino-2-methyl-propanoyl)-anthrachinon
2,7-Bis-(2-morpholino-2-methyl-propanoyl)-anthrachinon
2-(2-Piperidino-2-methyl-propanoyl)-anthrachinon
2-Methyl-1-(4-methylphenyl)-2-morpholino-propanon-1
1-(4-Methoxybenzoyl)-1-morpholino-cyclohexan
2-Methyl-1-[3,4-di(methylthio) phenyl]-2-morpholino-propanon-1
2-Methyl-1-[3-(2-hydroxyethylthio)-4-methoxyphenyl]-2-morpholino-propanon-1
2-Methyl-1-(N-methyl-carbazol-3-yl)-2-morpholino-propanon-1
2-Methyl-1-(N-methyl-phenothiazin-2-yl)-2-morpholino-propanon-1
2-Methyl-1-(N-methyl-phenoxazin-2-yl)-2-morpholino-propanon-1
2-Methyl-1-(phenoxathiin-3-yl)-2-morpholino-propanon-1
2-Methyl-1-(xanthen-2-yl)-2-morpholino-propanon-1
2-Methyl-1-(chroman-6-yl)-2-morpholino-propanon-1
2-Methyl-1-(N-methyl-indolin-5-yl)-2-morpholino-propanon-1
2-Methyl-1-(indan-5-yl)-2-morpholino-propanon-1
2-Methyl-1-(5,6,7,8-tetrahydro-2-naphthyl)-2-morpholino-propanon-1
2-Methyl-1-[5,10-bis(2-hydroxyethyl)-5,10-dihydrophenazin-2-yl]-2-morpholino-propanon-1
2-Methyl-1-[1,4-bis(2-hydroxyethyl)-1,2,3,4-tetrahydrochinoxalin-6-yl]-2-morpholino-propanon-1
2-Methyl-1-[2,3-dihydro-2,3-dimethyl-benzothiazol-5-yl]-2-morpholino-propanon-1
2-Methyl-1-(4-hydroxyphenyl)-2-morpholino-propanon-1
2-Methyl-1-(4-isopropyloxyphenyl)-2-[N-methyl-N-(2-hydroxyethyl)-amino]-propanon-1
1-(4-Acryloxybenzoyl)-1-morpholino-cyclohexan
2-Methyl-1-[3-methyl-4-(trimethylsilyloxy)-phenyl]-2-morpholino-propanon-1
1-(2,3-Dihydro-2-methyl-benzofuran-5-yl)-2-methyl-2-morpholino-propanon-1
2-Ethyl-1-[4-methoxy-3-(2-hydroxyethylthio)-phenyl]-2-morpholino-propanon-1
2-Methyl-1-(4-ethoxy-3-methylphenyl)-2-[N-(2-hydroxyethyl)-N-(2-methoxyethyl)-amino]-propanon-1
2-Methyl-1-(4-cumyl)-2-morpholino-butanon-1
[5,10-Di(2-hydroxyethyl)-5,10-dihydrophenazin-3-yl]-(1-morpholino-cyclohexyl)-keton
1-(1,4-Dimethyl-1,2,3,4-tetrahydrochinoxalin-6-yl)-2-methyl-2-morpholino-propanon-1
2-Methyl-1-(1,4-dimethyl-1,2,3,4-tetrahydro-chinoxalin-6-yl)-2-morpholino-propanon-1
2-Methyl-1-[5,10-bis(2-hydroxyethyl)-5,10-dihydro-phenazin-2-yl]-2-morpholino-propanon-1
2,8-Bis(α-morpholino-isobutyroyl)-5,10-bis(2-hydroxypropyl)-5,10-dihydro-phenazin
2-Methyl-1-(10-methyl-10-H-phenoxazin-2-yl)-2-morpholino-propanon-1
2-Methyl-1-(10-methyl-10-H-phenothiazin-3-yl)-2-morpholino-propanon-1

Beispiele für einzelne Verbindungen der Formel II sind :

N,N'-Bis(α-benzoyl-isopropyl)-piperazin
N,N'-Bis[α-(4-methylthiobenzoyl)-isopropyl]-piperazin
Bis-[α-(4-isopropylbenzoyl)-isopropyl]-amin
N,N'-Bis(α-benzoyl-isopropyl)-hexamethylendiamin
N,N'-Bis-[α-(4-morpholinobenzoyl) isopropyl] hexamethylendiamin
N,N'-Dimethyl-N,N'-bis-[α-(4-dimethylaminobenzoyl) isopropyl]-hexamethylendiamin
N,N'-Bis-[α-(4-(2-hydroxyethylthio) benzoyl) isopropyl]-piperazin
N,N'-Bis-[α-methyl-α-(4-methoxybenzoyl) propyl]-piperazin
N,N'-Bis-[α-(4-(methylthio) benzoyl) isopropyl] methylamin
N,N'-Bis-[α-(4-methoxybenzoyl) isopropyl]-N-(2-hydroxyethyl) amin
N,N'-Bis-[α-(4-(methylthio) benzoyl) isopropyl] hexamethylendiamin

N,N'-Dimethyl-N,N'-bis-[α-(methoxybenzoyl) isopropyl] hexamethylendiamin

In bestimmten Fällen kann es vorteilhaft sein, ein Gemisch von 2 oder mehr Photoinitiatoren der Formel I oder II zu verwenden oder ein Gemisch mit einem bekannten Photoinitiator, der nicht der Formel I oder II entspricht.

Die Photoinitiatoren der Formel I und II sind zum Teil bekannte Verbindungen, deren Herstellung, Eigenschaften und Verwendung in der EP-A-3002 beschrieben sind. Soweit die Verbindungen neu sind, können sie in analager Weise zu den bekannten Verbindungen hergestellt werden.

Beispiele für neue Verbindungen sind diejenigen Verbindungen der Formel I oder II, in denen Ar eine durch mindestens einen Rest -N($R^7$) ($R^8$) substituierte Phenyl-, Biphenylyl- oder Benzoylphenylgruppe darstellt. Diese Verbindungen enthalten also sowohl im aliphatischen Teil wie auch im aromatischen Teil des Moleküls mindestens je eine Aminogruppe. Diese Aminogruppen können identisch oder verschieden sein. Bevorzugt sind darunter solche Verbindungen, in denen Ar durch einen Rest —N($R^7$) ($R^8$) substituiertes Phenyl, Alkylphenyl, Halogenphenyl, insbesondere aber Phenyl ist, wobei dieser Substituent vorzugsweise in 4-Stellung steht.

Besonders bevorzugt sind solche Verbindungen, in denen Ar eine in 4-Stellung durch Dialkylamino, Di(alkoxyalkyl) amino, Morpholino, Piperidino oder 4-Methylpiperazino substituierte Phenylgruppe ist.

Beispiele für einzelne solcher Aminoarylketone sind die folgenden Verbindungen :

2-Methyl-1-(4-morpholinophenyl)-2-morpholino-propanon-1
2-Methyl-1-[4-(4-methylpiperazino) phenyl]-2-(4-methylpiperazino)-propanon-1
2-Methyl-1-[4-(di(2-methoxyethyl) amino) phenyl]-2-di(2-methoxyethyl)-amino-propanon-1
2-Methyl-1-[4-(dimethylamino) phenyl]-2-dimethylamino-propanon-1
2-Methyl-1-[4-(dimethylamino) phenyl]-2-morpholino-propanon-1
2-Methyl-1-(4-piperidinophenyl)-2-morpholino-propanon-1
2-Methyl-1-[4-(diethylamino) phenyl]-2-morpholino-propanon-1
2-Methyl-1-(4-morpholinophenyl)-2-morpholino-butanon-1
2-Methyl-1-[4-(di(2-methoxyethyl) amino) phenyl]-2-morpholino-propanon-1
2-Methyl-1-(4-morpholinophenyl)-2-di(2-methoxyethyl) amino-propanon-1
2-Methyl-1-(4-morpholinophenyl)-2-morpholino-pentanon-1
2-Ethyl-1-(4-morpholinophenyl)-2-morpholino-hexanon-1
1-[4-(Morpholino) benzoyl]-1-morpholino-cyclohexan
1-[4-(Dimethylamino) benzoyl]-1-morpholino-cyclohexan
1-[4-(Dimethylamino) benzoyl]-1-morpholino-cyclopentan
2-Ethyl-1-(4-morpholinophenyl)-2-morpholino-butanon-1
2-Propyl-1-(4-dimethylaminophenyl)-2-morpholino-pentanon-1
2-Methyl-1-(4-dimethylaminophenyl)-2-morpholino-butanon-1
2-Ethyl-1-(4-dimethylaminophenyl)-2-morpholino-hexanon-1
2-Methyl-1-(4-piperazinophenyl)-2-piperazino-propanon-1
2-Methyl-1-(4-dimethylaminophenyl)-2-piperidino-propanon-1
2-Methyl-1-(4-diethylaminophenyl)-2-diethylamino-propanon-1
2-Methyl-1-(4-methylpropylaminophenyl)-2-methylpropylamino-propanon-1
2-Methyl-1-[4-(N-(2-hydroxyethyl) piperazino) phenyl]-2-[N-(2-hydroxyethyl) piperazino]-propanon-1
2-Methyl-1-[4-(2,6-dimethylmorpholino) phenyl]-2-(2,6-dimethyl-morpholino)-propanon-1
2-Methyl-1-(4-dimethylaminophenyl)-2-(2,6-dimethylmorpholino)-propanon-1
2-Methyl-1-(4-dimethylaminophenyl)-2-(4-methylpiperazino)-propanon-1
2-Methyl-1-(4-dimethylaminophenyl)-2-piperazino-propanon-1
2-Methyl-1-(4-dimethylaminophenyl)-2-di(2-methoxyethyl) amino-propanon-1
2-Methyl-1-(4-pyrrolidinophenyl)-2-pyrrolidino-propanon-1
2-Methyl-1-[3,4-bis(dimethylamino) phenyl]-2-morpholino-propanon-1
2-Methyl-1-(3-dimethylaminophenyl)-2-morpholino-propanon-1
2-Methyl-1-(3-brom-4-dimethylamino-phenyl)-2-morpholino-propanon-1
2-Methyl-1-(4-dimethylamino-3-methyl-phenyl)-2-morpholino-propanon-1
2-Methyl-1-(3-dimethylamino-4-methoxy-phenyl)-2-morpholino-propanon-1
2-Methyl-1-(3-morpholino-4-methoxy-phenyl)-2-morpholino-propanon-1
2-Methyl-1-[3-dimethylamino-4-(methylthio)-phenyl]-2-morpholino-propanon-1
2-Methyl-1-[4-morpholino-3-(methylthio)-phenyl]-2-morpholino-butanon-1
N-Methyl-4,4'-bis(α-morpholino-isobutyroyl)-diphenylamin
N-(2-Hydroxyethyl)-4,4'-bis(α-morpholino-isobutyroyl)-diphenylamin
N,N'-Bis-[α-(4-morpholinobenzoyl) isopropyl]-piperazin
N,N'-Bis-[α-(methyl-α-(4-dimethylaminobenzoyl) propyl]-piperazin
N,N-Bis-[α-(4-dimethylaminobenzoyl) isopropyl]-methylamin
N,N-Bis-[α-(4-morpholinobenzoyl) isopropyl]-benzylamin
2-Methyl-1-(4-dimethylaminophenyl)-2-dimethylamino-butanon-1
2-Methyl-1-(4-dimethylaminophenyl)-2-dimethylamino-pentanon-1

2-Ethyl-1-(4-dimethylaminophenyl)-2-dimethylamino-hexanon-1
1-[4-(Dimethylamino) benzoyl]-1-dimethylamino-cyclohexan
2-Methyl-1-(3-brom-4-dimethylamino-phenyl)-2-dimethylamino-propanon-1
2-Methyl-1-[3,4-bis(dimethylamino)-phenyl]-2-dimethylamino-propanon-1
2-Methyl-1-(3-dimethylamino-4-morpholino-phenyl)-2-dimethylamino-propanon-1
2-Methyl-1-(4-methylaminophenyl)-2-dimethylamino-propanon-1
2-Methyl-1-(4-methylaminophenyl)-2-morpholino-propanon-1
2-Methyl-1-(4-methylaminophenyl)-2-methylamino-propanon-1
2-Methyl-1-(4-aminophenyl)-2-dimethylamino-propanon-1
2-Methyl-1-(4-aminophenyl)-2-morpholino-propanon-1
2-Methyl-1-(4-acetylamidophenyl)-2-dimethylamino-propanon-1
2-Methyl-1-(4-acrylamidophenyl)-2-morpholino-propanon-1
2-Methyl-1-[4-(N-(2-hydroxyethyl)-N-methyl-amino) phenyl]-2-dimethylamino-propanon-1
2-Methyl-1-(4-dimethylaminophenyl)-2-methylamino-propanon-1
2-Methyl-1-(4-dimethylaminophenyl)-2-allylamino-propanon-1
2-Methyl-1-(4-diallylaminophenyl)-2-diallylamino-propanon-1
2-Methyl-1-[4-(N-ethyl-N-methyl-amino) phenyl]-2-(N-ethyl-N-methylamino)-propanon-1
2-Methyl-1-(4-dimethylaminophenyl)-2-anilino-propanon-1

Bei der Herstellung dieser Verbindungen kann die Aminogruppe —N($R^7$)($R^8$) durch Umsetzung des entsprechenden Halogenaryl- oder Nitroarylketons mit einem Amin ($R^7$)($R^8$)NH eingeführt werden. Insbesondere 4-Fluorphenyl- und 4-Chlorphenylketone sind hierzu gut geeignet. Die Einführung der aliphatischen Aminogruppe —N($R^3$)($R^4$) nach den bekannten Methoden kann vor oder nach der Einführung von —N($R^7$)($R^8$) geschehen. Wenn —N($R^3$)($R^4$) mit —N($R^7$)($R^8$) identisch ist, so kann die Einführung beider Aminogruppen in einem Verfahrensschritt durchgeführt werden. In den folgenden Herstellungsbeispielen sind diese Verfahrensvarianten näher beschrieben.

Herstellungsbeispiele

2-(4-Fluorphenyl)-3,3-dimethyl-2-methoxy-oxiran

39,22 g (0,16 Mol) 2-Brom-1-(4-fluorphenyl)-2-methyl-propanon-1, hergestellt durch Bromieren von 1-(4-Fluorphenyl)-2-methylpropanon-1 analog der Vorschrift in der EP-Anmeldung Nr. 3002 werden in 50 ml Methanol gelöst. Dann werden bei Raumtemperatur 23,5 g (0,176 Mol) methanolische 30 %ige Natriumethylat-Lösung zugetropft. Anschliessend wird das Methanol abdestilliert und der Rückstand wird in Diethylether aufgenommen. Das Salz wird abfiltriert und die Etherlösung eingeengt. Das flüssige Rohrprodukt wird ohne weitere Reinigung wie nachfolgend beschrieben weiter umgesetzt.

1-(4-Fluorphenyl)-2-methyl-2-morpholino-propanon-1

29,43 g (0,15 Mol) 2-(4-Fluorphenyl)-3,3-dimethyl-2-methoxy-oxiran und 52,3 g (0,60 Mol) Morpholin werden zusammengegeben und auf Rückfluss (ca. 130 °C) erwärmt. Nach 23 Stunden wird das überschüssige Morpholin abdestilliert. Der Rückstand wird in Toluol aufgenommen und mit verdünnter Salzsäure extrahiert. Die Salzsäurelösung wird alkalisch gestellt und mit Toluol extrahiert. Die Toluollösung wird mit $K_2CO_3$ getrocknet und eingeengt. Der Rückstand, 34,5 g, kristallisiert aus Ethylacetat, Smp. 63-66 °C.

| | | | |
|---|---|---|---|
| $C_{14}H_{18}FNO_2$ | (251,30) | | |
| berechnet : | C 66,91 | H 7,22 | N 5,57 % |
| gefunden : | C 66,86 | H 7,18 | N 5,62 % |

2-Methyl-1-(4-morpholinophenyl)-2-morpholino-propanon-1

15,08 g (0,06 (Mol) 1-(4-Fluorphenyl)-2-methyl-2-morpholino-propanon-1 und 5,23 g (0,06 Mol) Morpholin werden in 25 ml Dimethylsulfoxid gelöst und zusammen mit 8,3 g (0,06 Mol) Kaliumcarbonat auf 160 °C geheizt. Nach 18 Stunden Rühren bei ca. 160 °C wird die Suspension abgekühlt und auf ein Eis-Wasser-Gemisch gegossen. Die Kristalle werden abfiltriert, mit Wasser gewaschen und aus Ethanol umkristallisiert. Smp. 114-116 °C.

| | | | | |
|---|---|---|---|---|
| $C_{18}H_{26}N_2O_3$ | (318,42) | | | |
| berechnet : | C 67,90 | H 8,23 | N 8,80 | O 15,07 % |
| gefunden : | C 67,89 | H 8,04 | N 8,82 | O 15,16 % |

Die Struktur wird durch das $^1$H-NMR-Spektrum bestätigt.

1-(4-Fluorphenyl)-2-methyl-2-(4-methylpiperazino)-propanon-1

29,43 g (0,15 Mol) 2-(4-Fluorphenyl)-3,3-dimethyl-2-methoxy-oxiran und 60,1 g (0,60 Mol) 1-Methylpiperazin werden zusammengegeben und auf ca. 125 °C erwärmt. Nach 8 Stunden wird abgekühlt und das überschüssige 1-Methylpiperazin abdestilliert. Der Rückstand wird in Toluol aufgenommen und mit verdünnter Salzsäure extrahiert. Die Salzsäurelösung wird alkalisch gestellt und mit Toluol extrahiert. Die Toluollösung wird mit $K_2CO_3$ getrocknet und eingeengt. Der Rückstand, 29,4 g eines cognacfarbenen Oels, wird anschliessend weiter umgesetzt.

2-Methyl-1-[4-(4-methylpiperazino)phenyl]-2-(4-methylpiperazino)-propanon-1

13,2 g (0,05 Mol) 1-(4-Fluorphenyl)-2-methyl-2-(4-methylpiperazino)-propanon-1 und 6,5 g (0,065 Mol) 1-Methylpiperazin werden in 20 ml Dimethylsulfoxid gelöst und zusammen mit 6,9 g (0,05 Mol) Kaliumcarbonat auf ca. 115 °C geheizt. Nach 15 Stunden Rühren bei ca. 115 °C wird die Suspension abgekühlt und bei ca. 60 °C auf Eis gegossen. Die Kristalle werden abfiltriert und zweimal aus Ethylacetat umkristallisiert. Smp. 133-136 °C.

| | | | | |
|---|---|---|---|---|
| $C_{20}H_{32}N_4O$ | (344,50) | | | |
| berechnet : | C 69,73 | H 9,36 | N 16,26 % | |
| gefunden : | C 59,58 | H 9,34 | N 16,24 % | |

Die Struktur wird durch das $^1$H-NMR-Spektrum bestätigt.

In analoger Weise werden aus den entsprechenden 2-(4-Fluorphenyl)-3,3-dialkyl-2-methoxy-oxiranen durch zweistufige Amin-Umsetzung die folgenden Verbindungen hergestellt :

2-Methyl-1-(4-morpholinophenyl)-2-di-(2-methoxyethyl)-amino-propanon-1, viskoses Oel,

| | | | | |
|---|---|---|---|---|
| $C_{20}H_{32}N_2O_4$ | ber. : | C 65,90 | H 8,85 | N 7,68 % |
| (364,49) | gef. : | C 65,00 | H 8,95 | N 7,16 % |

2-Methyl-1-(4-morpholinophenyl)-2-morpholino-butanon-1
Smp. 111-114 °C (Ethanol)

| | | | | |
|---|---|---|---|---|
| $C_{19}H_{28}N_2O_3$ | ber. : | C 68,63 | H 8,49 | N 8,42 % |
| (332,45) | gef. : | C 68,63 | H 8,43 | N 8,39 % |

2-Methyl-1-(4-dimethylaminophenyl)-2-morpholino-propanon-1
Smp. 152-155 °C (Ethanol)

| | | | | |
|---|---|---|---|---|
| $C_{16}H_{24}N_2O_2$ | ber. : | C 69,53 | H 8,75 | N 10,14 % |
| (276,38) | gef. : | C 69,54 | H 8,70 | N 10,17 % |

2-Methyl-1-(4-diethylaminophenyl)-2-morpholino-propanon-1
Smp. 86-89 °C (Isopropanol)

| | | | | |
|---|---|---|---|---|
| $C_{18}H_{28}N_2O_2$ | ber. : | C 71,02 | H 9,27 | N 9,20 % |
| (304,44) | gef. : | C 70,57 | H 9,16 | N 9,08 % |

Die Strukturen werden durch $^1$H-NMR-Spektren bestätigt.

1-[4-(Dimethylamino) phenyl]-2-dimethylamino-2-methyl-propanon-1

29,4 g (0,15 Mol) 2-(4-Fluorphenyl)-3,3-dimethyl-2-methoxy-oxiran und 50 ml Toluol werden in einer Hochdruckapparatur vorgelegt. Dann werden 27 g (0,60 Mol) Dimethylamingas zugepresst. Die Mischung wird auf 130 °C gehalten (Maximaldruck 39 bar). Der Endpunkt der Reaktion wird gaschromatographisch bestimmt. Die Lösung wird eingeengt und die gelben Kristalle werden in Toluol gelöst. Die Lösung wird mit verdünnter Salzsäure extrahiert. Die Salzsäurelösung wird mit Toluol versetzt und alkalisch gestellt. Die Toluolphase wird abgetrennt, mit $K_2CO_3$ getrocknet und am Rotationsverdampfer eingeengt. Der Rückstand wird aus Isopropanol imkristallisiert. Smp. 89-91 °C.

| | | | | |
|---|---|---|---|---|
| $C_{14}H_{22}N_2O$ | ber. : | C 71,76 | H 9,46 | N 11,95 % |
| (234,34) | gef. : | C 71,69 | H 9,56 | N 11,99 % |

2-Methyl-1-(4-piperidinophenyl)-propanon-1

49,86 (0,30 Mol) 1-(4-Fluorphenyl)-2-methyl-propanon-1, hergestellt durch eine Friedel-Crafts-Reaktion von Isobuttersäurechlorid mit Fluorbenzol analog der Vorschrift in der EP-Anmeldung Nr. 3002, und 25,5 g (0,30 Mol) Piperidin werden in 120 ml Dimethylsulfoxid gelöst und zusammen mit 41,5 g (0,30 Mol) Kaliumcarbonat auf 110 °C geheizt. Nach 16 Stunden Rühren bei 110 °C wird die Suspension abgekühlt und auf ein Eis-Wasser-Gemisch gegossen. Die Kristalle werden abfiltriert, mit Wasser gewaschen und aus Hexan umkristallisiert.

| | | | | |
|---|---|---|---|---|
| $C_{15}H_{21}NO$ | (231,34) | Smp. 57-60 °C | | |
| berechnet : | C 77,87 | H 9,14 | N 6,05 % | |
| gefunden : | C 77,59 | H 9,26 | N 5,96 % | |

2-Brom-2-methyl-1-(4-piperidinophenyl)-propanon-1

34,70 g (0,15 Mol) 2-Methyl-1-(4-piperidinophenyl)-propanon-1 werden in 200 ml Eisessig gelöst. Als Katalysator werden 0,58 g (5,0 mMol) Chlorsulfonsäure (entsprechend 0,33 ml) zugegeben. Dann werden in ca. einer Stunde bei Raumtemperatur unter gutem Rühren 24,0 g (0,15 Mol) Brom zugetropft. Die Lösung wird dann auf Eis gegossen und mit verdünnter Natronlauge auf ca. pH 6 gestellt. Die ausgefallenen Kristalle werden mit Toluol extrahiert. Die Toluollösung wird mit $Na_2SO_4$ getrocknet und am Rotationsverdampfer bei 40 °C unter Vacuum eingeengt. Die langsam kristallisierende, orange Flüssigkeit, wird anschliessend weiter umgesetzt.

3,3-Dimethyl-2-methoxy-2-(4-piperidinophenyl)-oxiran

12,0 g (38,7 mMol) 2-Brom-2-methyl-1-(4-piperidinophenyl)-propanon-1 werden in 20 ml Methanol gelöst, dann werden bei Raumtemperatur 7,0 g (46,4 mMol) methanolische 30 %ige Natriummethylat-Lösung zugetropft. Anschliesend wird das Methanol unter Vacuum abdestilliert. Der Rückstand wird in Toluol aufgenommen und das ausgefallene Salz wird abfiltriert. Die Lösung wird unter Vacuum eingeengt. Der braune Rückstand, eine langsam kristallisierende Flüssigkeit, wird direkt weiter umgesetzt.

2-Methyl-2-morpholino-1-(4-piperidinophenyl)-propanon-1

12,1 g (46,3 mMol) 3,3-Dimethyl-2-methoxy-2-(4-piperidinophenyl)-oxiran und 26,1 g (0,30 Mol) Morpholin werden zusammengegeben und auf Rückfluss (ca. 130 °C) aufgeheizt. Nach 6 Stunden wird abgekühlt und das Morpholin unter Vacuum abdestilliert. Der Rückstand wird in Toluol aufgenommen und mit verdünnter Salzsäure extrahiert. Die Salzsäurelösung wird alkalisch gestellt und mit Toluol extrahiert. Die Toluollösung wird mit $K_2CO_3$ getrocknet und eingeengt. Der Rückstand wird aus Methanol umkristallisiert. Smp. 159-162 °C.

| | | | |
|---|---|---|---|
| $C_{19}H_{28}N_2O_2$ | (316,45) | | |
| berechnet : | C 72,11 | H 8,91 | N 8,85 % |
| gefunden : | C 72,12 | H 8,96 | N 8,82 % |

Die Struktur wird durch das $^1$H-NMR-Spektrum bestätigt.

Die Menge an Photoinitiator der Formel I oder II im photopolymerisierbaren Gemisch beträgt etwa 0,2 bis 20 Gew.-%, vorzugsweise 1-6 Gew.-%.

Beim Einsatz in photopolymerisierbaren wässrigen Dispersionen oder Emulsionen kann es zweckmässig sein, anstelle der Photoinitiatoren gemäss Formel I oder II deren Salze mit organischen bzw. anorganischen Säuren zu verwenden. Diese Salze besitzen eine deutlich bessere Wasserlöslichkeit und lassen sich leichter in die wässrigen Systeme einarbeiten.

Das Gemisch enthält als Komponente C) einen Photosensibilisator aus der Gruppe der aromatischen Carbonylverbindungen mit einer Triplettenergie von 225-310 kJ/mol.

Solche Verbindungsklassen sind z. B. Xanthone, Thioxanthone, Phthalimide, Anthrachinone, Acetophenone, Propiophenone, Benzophenone, Acylnaphthaline, 2-(Acylmethylen)-thiazoline, 3-Acylcumarine oder 3,3'-Carbonyl-biscumarine.

Bevorzugt sind als Sensibilisatoren Thioxanthone, 3-Acylcumarine und 2-(Aroylmethylen)-thiazoline, insbesondere aber Thioxanthone und 3-Aroylcumarine.

Beispiele für einzelne erfindungsgemäss als Photosensibilisatoren verwendbare Verbindungen sind :

Xanthon
Thioxanthon
2-Isopropylthioxanthon
2-Chlorthioxanthon
2-Dodecylthioxanthon
1-Methoxycarbonylthioxanthon

2-Ethoxycarbonylthioxanthon
3-(2-Methoxyethoxycarbonyl)-thioxanthon
4-Butoxycarbonylthioxanthon
3-Butoxycarbonyl-7-methyl-thioxanthon
1-Cyano-3-chlorthioxanthon
1-Ethoxycarbonyl-3-chlor-thioxanthon
1-Ethoxycarbonyl-3-ethoxythioxanthon
1-Ethoxycarbonyl-3-aminothioxanthon
1-Ethoxycarbonyl-3-phenylsulfuryl-thioxanthon
3,4-Di-[2-(2-methoxyethoxy) ethoxycarbonyl]-thioxanthon
1-Ethoxycarbonyl-3-(1-methyl-1-morpholinoethyl)-thioxanthon
2-Methyl-6-dimethoxymethyl-thioxanthon
2-Methyl-6-(1,1-dimethoxybenzyl)-thioxanthon
2-Morpholinomethyl-thioxanthon
2-Methyl-6-morpholinomethyl-thioxanthon
N-Allyl-thioxanthon-3,4-dicarboximid
N-Octyl-thioxanthon-3,4-dicarboximid
N-(1,1,3,3-Tetramethylbutyl)-thioxanthon-3,4-dicarboximid
6-Ethoxycarbonyl-2-methoxythioxanthon
6-Ethoxycarbonyl-2-methyl-thioxanthon
Thioxanthon-2-carbonsäure-polyethylenglykolester.
3-Phenylthio-phthalimid
N-Methyl-3,5-di(ethylthio)-phthalimid
3-Benzoyl-cumarin
3-Benzoyl-7-methoxy-cumarin
3-Benzoyl-5,7-di(propoxy)-cumarin
3-Benzoyl-6,8-dichlorcumarin
3-Benzoyl-6-chlorcumarin
3,3'-Carbonyl-bis [5,7-di(propoxy)-cumarin]
3,3'-Carbonyl-bis(6,8-dichlorcumarin)
3-Isobutyroyl-cumarin
3-Benzoyl-5,7-dimethoxy-cumarin
3-Benzoyl-5,7-diethoxycumarin
3-Benzoyl-5,7-dibutoxycumarin
3-Benzoyl-5,7-di(methoxyethoxy) cumarin
3-Benzoyl-5,7-di(allyloxy) cumarin
Acetophenon
3-Methoxyacetophenon
4-Phenylacetophenon
Benzaldehyd
Benzophenon
4-Phenylbenzophenon
4-Methoxybenzophenon
4,4'-Dimethoxy-benzophenon
4,4'-Dimethyl-benzophenon
4-Methylbenzophenon
4-(2-Hydroxyethylthio)-benzophenon
4-(4-Tolylthio)-benzophenon
2-Acetylnaphthalin
2-Naphthaldehyd
3-Methyl-2-benzoylmethylen-β-naphthothiazolin
3-Methyl-2-benzoylmethylen-benzothiazolin
3-Ethyl-2-propionylmethylen-β-naphthothiazolin.

Besonders bevorzugt sind Thioxanthone und 3-Acylcumarine mit einer Triplettenergie von 225-276 kJ/mol.

Die Menge an Photosensibilisator im photopolymerisierbaren Gemisch beträgt etwa 0,01 bis 5 Gew.-%, vorzugsweise 0,025 bis 2 Gew.-%.

Diese Sensibilisatoren der Komponente C) erhöhen die Aktivität der Photoinitiatoren B) ohne die Lagerstabilität der Gemische zu verringern. Besonders ausgeprägt ist die Wirkungssteigerung in pigmentierten Systemen wie in Druckfarben oder Weisslacken. Ein besonderer Vorteil der Gemische liegt darin, dass durch gezielte Auswahl eines Photosensibilisators C die spektrale Empfindlichkeit des Photoinitiators B in beliebige Wellenlängebereiche verschoben werden kann. Bisher konnte eine solche Verschiebung der spektralen Empfindlichkeit von Photoinitiatoren nur durch aufwendige und teure synthetische Modifikation des Photoinitiators erreicht werden. Dadurch, dass eine Vielzahl von Photosensibilisatoren zur Verfügung steht, lässt sich der gewünschte Effekt somit ohne Schwierigkeit aufwendige Synthese durch Herstellung der erfindungsgemässen Gemische erzielen. Viele dieser Sensibilisatoren haben darüber hinaus den Vorteil, dass sie mit sichtbarem Licht angeregt werden können.

Die photohärtbaren Gemische können für verschiedene Zwecke verwendet werden. In erster Linie ist ihre Verwendung in pigmentierten oder eingefärbten Systemen von Bedeutung, wie z. B. für Druckfarben, für photographische Reproduktionsverfahren, Bildaufzeichnungsverfahren und zur Herstellung von Reliefformen.

Ein weiteres wichtiges Einsatzgebiet sind Anstrichstoffe, die pigmentiert oder unpigmentiert sein können. Besonders wertvoll sind die Gemische in Weisslacken, darunter versteht man durch $TiO_2$ pigmentierte Anstrichstoffe. Weitere Einsatzgebiete sind die Strahlenhärtung von Photoresists, die Photovernetzung silberfreier Filme sowie die Herstellung von Druckplatten.

Eine interessante Anwendung sind auch photohärtende Mikrokapseln, bzw. daraus hergestellte Bildaufzeichnungs- bzw. Photokopiersysteme. Solche Systeme sind z. B. in der DE-OS 3,226,608 beschrieben. Der Vorteil der vorliegenden Gemische liegt darin, dass man die spektrale Empfindlichkeit der photohärtenden Mikrokapseln beliebig einstellen kann. Hierdurch lassen sich z. B. bequem auch Kopiersysteme für Farbphotokopien herstellen, wenn man Mikrokapseln einsetzt, die bei 3 verschiedenen Wellenlängen (entsprechend den 3 Komplementärfarben des sichtbaren Lichts) aushärten.

Je nach ihrem Verwendungszweck können die photopolymerisierbaren Gemische weitere Zusätze enthalten, beispielsweise Pigmente, Farbstoffe und deren Vorläufer, Füllstoffe, Lösungsmittel, Verlaufshilfsmittel, Thixotropiemittel oder Netzmittel. Weitere mögliche Zusätze sind Stabilisatoren, wie z. B. Lichtschutzmittel, UV-Absorber, Antioxidantien, Polymerisationsinhibitoren, Korrosionsschutzmittel oder radikalische Polymerisationsinitiatoren.

Die Applikation der photopolymerisierbaren Gemische erfolgt durch Auftrag auf das Substrat in dünner Schicht nach den hierfür üblichen Techniken, z. B. durch Besprühen, Streichen oder Tauchen. In bestimmten Fällen kann das Gemisch über die Schmelze zu photohärtbaren Filmen verarbeitet werden, die sich auf beliebige Substrate aufbringen lassen. Die Härtung des Filmes erfolgt anschliessend durch Bestrahlung mit Licht, vorzugsweise mit UV-Licht vom Wellenlängenbereich 250-500 nm. Als Lichtquellen sind hierzu z. B. Quecksilbermitteldruck-, -hochdruck und -niederdruckstrahler, superaktinische Leuchtstoffröhren sowie Metallhalogenid-Lampen geeignet. Vorzugsweise wird die Strahlungshärtung in kontinuierlichem Verfahren durchgeführt, wobei das zu härtende Material unter der Strahlenquelle vorbeitransportiert wird. Die Transportgeschwindigkeit ist massgeblich für die Produktionsgeschwindigkeit des Artikels ; sie hängt von der benötigten Bestrahlungszeit ab. Deshalb ist die Beschleunigung der Strahlenhärtung durch Photoinitiatoren ein wichtiger Faktor für die Produktion solcher Artikel und es ist einer der Vorteile der Kombination von B) und C), dass sie bereits in niedriger Konzentration auch bei Massen mit hohem Pigmentgehalt eine rasche Härtung gewährleistet. Bei der Herstellung von Reliefformen oder graphischen Reproduktions- oder Bildaufzeichnungsverfahren schliesst sich der Belichtung ein Entwicklungsprozess an.

Die folgenden Beispiele erläutern die Erfindung näher ohne sie darauf zu beschränken.

## Beispiel 1

Es wird ein Weisslack nach folgender Rezeptur hergestellt :

17,6 g Ebecryl® 593 (Polyesteracrylatharz der Fa. UCB, Belgien),
11,8 g N-Vinylpyrrolidon
19,6 g Titandioxid RTC-2 (Titandioxid der Fa. Tioxide, England),
19,6 g Sachtolith® HDS (Lithopone der Sachtleben Chemie, BRD),
11,8 g Trimethylolpropan-trisacrylat,
19,6 g Setalux® UV 2276 (acryliertes Epoxidharz auf der Basis von Bisphenol A, Kunstharzfabrik Synthese, Holland).

Die obigen Komponenten werden zusammen mit 125 g Glasperlen (Durchmesser 4 cm) in einer 250 ml Glasflasche während mindestens 24 Stunden auf eine Korngrösse von maximal 5 μm gemahlen.

Die so erhaltene Stammpaste wird in Portionen geteilt und jede Portion mit den in der Tabelle 1 angegebenen Photoinitiatoren und Photosensibilisatoren (Co-Initiatoren) durch Einrühren bei 60 °C gemischt und die Mischungen nochmals 16 Stunden mit Glasperlen gemahlen.

Die so hergestellten Weisslacke werden in einer Dicke von 30 μm mit einer Rakel auf Glasplatten aufgetragen. Die Proben werden in einem PPG-Bestrahlungsgerät mit einer Lampe von 80 W/cm in einem Durchgang belichtet. Dabei wird die Geschwindigkeit des Durchganges der Proben durch das Bestrahlungsgerät laufend gesteigert bis keine ausreichende Härtung mehr eintritt. Die maximale Geschwindigkeit, bei der noch ein wischfester Lackfilm entsteht, ist in Tabelle 1 als « Härtungsgeschwindigkeit » angegeben.

Hierbei werden folgende Verbindungen verwendet :
PI 2 = 1-Phenyl-2-methyl-2-morpholino-propanon-1

PI 3 = 1-(4-Chlorphenyl)-2-methyl-2-morpholino-propanon-1
PI 4 = 1-(4-Toluyl)-2-methyl-2-morpholino-propanon-1
PS 1 = 2-Methyl-6-ethoxycarbonyl-thioxanthon

Tabelle 1

| Photoinitiator | Co-Initiator (Sensibilisator) | Härtungsgeschwindigkeit |
|---|---|---|
| 2 % PI 2 | 0,25 % PS 1 | 30 m/min. |
| 2 % PI 3 | 0,25 % PS 1 | 40. m/min. |
| 2 % PI 4 | 0,25 % PS 1 | 60 m/min. |

Beispiel 2

Es wird wie in Beispiel 1 gearbeitet, jedoch werden die Proben in einem Bestrahlungsgerät der Fa. Fusion System (USA) mit einer D-Lampe gehärtet. Das Strahlungsmaximum dieser Lampe ist längerwellig als das der UV-Lampe im PPG-Gerät des Beispiels 1.

Als Photoinitiatoren werden je 2 % PI 1 (= 1-(4-Methylthiophenyl)-2-methyl-2-morpholino-propanon-1) und PI 5 (= 2-Methyl-1-(4-morpholinophenyl)-2-morpholino-propanon-1) verwendet.

Als Sensibilisatoren (je 0,5 %) werden verwendet:
PS 1 = 2-Methyl-6-ethoxycarbonyl-thioxanthon
PS 5 = 2-Isopropyl-thioxanthon
PS 6 = 1-Methyl-2-benzoylmethylen-β-naphthothiazolin

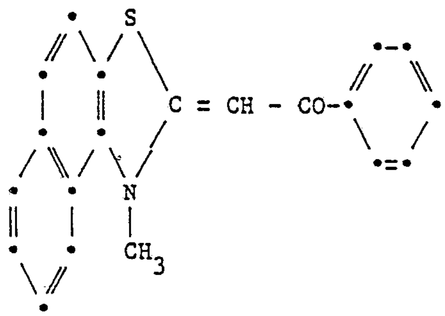

PS 7 = 3-Benzoyl-5,7-dipropoxycumarin

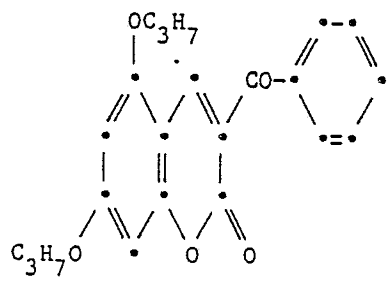

Tabelle 2

| Photoinitiator | Co-Initiator (Sensibilisator) | Härtungsgeschwindigkeit m/min. |
|---|---|---|
| 2 % PI 1 | - | 20 |
| 2 % PI 1 | 0,5 % PS 6 | 40 |
| 2 % PI 1 | 0,5 % PS 7 | 50 |
| 2 % PI 5 | - | 40 |
| 2 % PI 5 | 0,5 % PS 1 | > 200 |
| 2 % PI 5 | 0,5 % PS 5 | 80 |
| 2 % PI 5 | 0,5 % PS 6 | 60 |
| 2 % PI 5 | 0.5 % PS 7 | > 200 |

Beispiel 3

Es wird ein Weisslack nach folgender Rezeptur hergestellt :

38,5 g Actylan® AJ 18 (Polyurethanacrylat der Fa. SNPE, Frankreich)
19,2 g N-Vinylpyrrolidon
38,5 g Titandioxid RTC-2 (Fa. Tioxide, England)
3,8 g Butylacetat

Wie im Beispiel 1 beschrieben werden aus einer Stammpaste durch Zumischen der in Tabelle 3 aufgeführten Photoinitiatoren und Co-Initiatoren und Mahlen die einzelnen Proben bereitet. Diese werden mit einer Rakel von 30 μm Spaltöffnung auf Glasplatten aufgetragen. Die Härtung der Proben geschah einerseits in einem PPG-Bestrahlungsgerät mit einer 80 W-Lampe, andererseits in einem Bestrahlungsgerät der Fa. Fusion Systems (USA) mit einer D-Lampe : Die beiden Lampen unterscheiden sich in ihrem Strahlenspektrum.

Es werden folgende Photoinitiatoren verwendet :

PI 5 = 2-Methyl-1-(4-morpholinophenyl)-2-morpholino-propanon-1
PI 6 = 2-Methyl-1-[4-(4-methylpiperazino)-phenyl]-2-(4-methylpiperazino)-propanon-1
PI 7 = 2-Methyl-1-(4-dimethylaminophenyl)-2-dimethylamino-propanon-1
PI 8 = 2-Methyl-1-(4-piperidinophenyl)-2-morpholino-propanon-1
PI 9 = 2-Methyl-1-(4-dimethylaminophenyl)-2-morpholino-propanon-1
PI 10 = 2-Methyl-1-(4-morpholinophenyl)-2-di(2-methoxyethyl) amino-propanon-1
PI 11 = 2-Methyl-1-(4-morpholinophenyl)-2-morpholino-butanon-1
PI 12 = 2-Methyl-1-(4-diethylaminophenyl)-2-morpholino-propanon-1

Als Co-Initiator (Sensibilisator) werden verwendet :

PS 1 = 2-Methyl-6-ethoxycarbonyl-thioxanthon
PS 5 = 2-Isopropyl-thioxanthon
PS 7 = 3-Benzoyl-5,7-dipropoxy-cumarin

Tabelle 3

| Photo-initiator | Sensi-bilisator | Härtung im PPG-Gerät | | mit Fusion-D-Lampe | |
|---|---|---|---|---|---|
| | | Maximale Geschwindigkeit (m/min) | Pendelhärte (sec.) | Maximale Geschwindigkeit (m/min) | Pendelhärte (sec.) |
| 2 % PI 5 | - | 20 | 40 | 40 | 34 |
| 2 % PI 5 | 0,25 % PS 1 | 50 | 26 | > 200 | 28 |
| 2 % PI 5 | 0,25 % PS 5 | 40 | 37 | 190 | 43 |
| 2 % PI 5 | 0,5 % PS 1 | 70 | 31 | > 200 | 35 |
| 2 % PI 6 | - | 20 | 45 | 50 | 50 |
| 2 % PI 6 | 0,5 % PS 1 | 30 | 21 | 80 | 20 |
| 2 % PI 7 | - | 40 | 42 | 100 | 43 |
| 2 % PI 7 | 0,5 % PS 1 | 100 | 22 | > 200 | 35 |
| 2 % PI 8 | - | 20 | 50 | 30 | 52 |
| 2 % PI 8 | 0,5 % PS 1 | 80 | 31 | > 200 | 34 |
| 2 % PI 9 | - | 20 | 50 | 30 | 50 |
| 2 % PI 9 | 0,5 % PS 1 | 70 | 22 | > 200 | 31 |
| 2 % PI 9 | 0,5 % PS 7 | 70 | 30 | > 200 | 50 |
| 2 % PI 10 | - | 20 | 33 | 80 | 38 |
| 2 % PI 10 | 0,5 % PS 1 | 100 | 34 | > 200 | 40 |
| 2 % PI 11 | - | 20 | 43 | 30 | 43 |
| 2 % PI 11 | 0,5 % PS 1 | 70 | 31 | > 200 | 31 |
| 2 % PI 12 | - | 20 | 46 | 30 | 51 |
| 2 % PI 12 | 0,5 % PS 1 | 50 | 42 | > 200 | 28 |

Beispiel 4

Eine blaue Druckfarbe wird nach folgender Rezeptur hergestellt :

62 Teile Setalin® AP 565 (Urethanacrylatharz der Fa. Synthese, Holland),
15 Teile 4,4'-Di-(β-acryloyloxyethoxy)-diphenylpropan-2,2 (Ebecryl® 150, UCB, Belgien)
23 Teile Irgalithblau® GLSM (Ciba-Geigy AG, Basel).

Das Gemisch wird auf einem 3-Walzenstuhl homogenisiert und bis auf eine Korngrösse von $< 5\ \mu$ gemahlen.

Von dieser Druckfarbe werden jeweils 5 g mit der gewünschten Menge an Photoinitiator auf einer Tellerreibmaschine unter einem Druck von 180 $kg/m^2$ unter Wasserkühlung homogen vermischt.

Von dieser Druckfarbe werden mit einem Probedruckgerät (Fa. Prüfbau, BR Deutschland) Offsetdrucke auf 4 × 20 cm Streifen aus Kunstdruckpapier gemacht. Die Druckbedingungen sind

| | |
|---|---|
| Auflage Druckfarbe | 1,5 $g/m^2$ |
| Anpressdruck | 25 $kg/cm^2$ |
| Druckgeschwindigkeit | 1 m/sec |

Hierbei wird eine Druckwalze mit Metalloberfläche (Aluminium) verwendet.

Die bedruckten Proben werden in einem UV-Bestrahlungsgerät der Fa. PPG gehärtet, und zwar einmal mit einer Lampe und einmal mit zwei Lampen von je 80 W/cm. Weitere Proben werden in einem Bestrahlungsgerät der Fa. Fusion Systems (USA) mit einer D-Lampe gehärtet, deren Strahlungsspektrum längerwellig als das der PPG-Lampen ist. Die Bestrahlungszeit wird durch Variation der Transportgeschwindigkeit der Probe variiert.

Die Oberflächentrocknung der Druckfarbe wird unmittelbar nach der Bestrahlung durch den sogenannten Transfer-Test geprüft. Dabei wird ein weisses Papier unter einem Druck von 25 $kg/cm^2$ an die bedruckte Probe angepresst. Wenn das Papier farblos bleibt, ist der Test bestanden. Wenn sichtbare Mengen Farbe auf den Teststreifen übertragen werden, so ist dies ein Zeichen, dass die Oberfläche der Probe noch nicht genügend gehärtet ist.

In den Tabellen 4a-4c ist die maximale Transportgeschwindigkeit angegeben, bei der der Transfer-Test noch bestanden wurde.

Zur Prüfung der Durchhärtung der Druckfarbe werden ebenfalls Offset-Drucke hergestellt wie vorhin beschrieben, jedoch werden Druckwalzen mit Gummi-Oberfläche verwendet und es wird die Metallseite von Aluminium-beschichteten Papierstreifen bedruckt.

Die Bestrahlung geschieht wie oben beschrieben. Unmittelbar nach der Bestrahlung wird die Durchhärtung in einem REL-Durchhärtungsprüfgerät getestet. Dabei wird auf die bedruckte Probe ein mit Stoff überspannter Aluminium-Zylinder aufgesetzt und unter einem Druck von 220 $g/cm^2$ innerhalb 10 sec einmal um die eigene Achse gedreht. Wenn dabei auf der Probe sichtbare Beschädigungen entstehen, so ist die Druckfarbe ungenügend durchgehärtet. In den Tabellen wird die maximale Transportgeschwindigkeit angegeben, bei der der REL-Test noch bestanden wurde.

Tabelle 4a Härtung im PPG-Gerät mit 80 W/cm-Lampe

| Photo-initiator | Photo-sensibili-sator | Maximale Transportgeschwindigkeit (m/min) | |
|---|---|---|---|
| | | Transfer-Test | REL-Test |
| 2 % PI 5 | - | 50 | 30 |
| 2 % PI 5 | 0,5 % PS 1 | 50 | 40 |
| 2 % PI 5 | 0,5 % PS 5 | 50 | 30 |
| 3 % PI 5 | - | 70 | 40 |
| 3 % PI 5 | 0,5 % PS 5 | 80 | 50 |
| 3 % PI 5 | 1 % PS 5 | 110 | 60 |

(Siehe Tabelle 4b Seite 18 f.)

Tabelle 4b Härtung im PPG-Gerät mit 160 W/cm

| Photo-initiator | Photo-sensibili-sator | Maximale Transportgeschwindigkeit (m/min) | |
|---|---|---|---|
| | | Transfer-Test | REL-Test |
| 2 % PI 5 | - | 90 | 50 |
| 2 % PI 5 | 0,5 % PS 1 | 100 | 80 |
| 2 % PI 5 | 0,5 % PS 5 | 100 | 70 |
| 3 % PI 5 | - | 130 | 90 |
| 3 % PI 5 | 0,5 % PS 5 | 140 | 100 |
| 3 % PI 5 | 1 % PS 5 | 170 | 130 |

Tabelle 4c Härtung mit Fusion D-Lampe

| Photo-initiator | Photo-sensibili-sator | Maximale Transportgeschwindigkeit (m/min) | |
|---|---|---|---|
| | | Transfer-Test | REL-Test |
| 2 % PI 5 | - | 60 | 40 |
| 2 % PI 5 | 0,5 % PS 1 | 70 | 90 |
| 2 % PI 5 | 0,5 % PS 5 | 60 | 80 |
| 3 % PI 5 | - | 120 | 80 |
| 3 % PI 5 | 0,5 % PS 5 | 140 | 100 |
| 3 % PI 5 | 1 % PS 5 | 170 | 130 |

Beispiel 5

Die in Beispiel 4 beschriebene blaue Druckfarbe wird mit jeweils 3 und 6 % der in Tabelle 5 aufgeführten Photoinitiatoren vermischt. Die Bereitung der Proben und ihre Testung geschieht wie in Beispiel 5 beschrieben. Die Härtung geschieht in einem PPG-Gerät mit einer Lampenleistung von 160 W/cm.

Tabelle 5

| Photoinitiator | Maximale Transportgeschwindigkeit (m/min) | |
|---|---|---|
| | Transfer-Test | REL-Test |
| 3 % PI 6 | 70 | 40 |
| 6 % PI 6 | > 170 | 170 |
| 3 % PI 7 | > 170 | 120 |
| 6 % PI 7 | > 170 | > 170 |
| 3 % PI 10 | > 170 | 100 |
| 6 % PI 10 | > 170 | 170 |
| 3 % PI 11 | 120 | 60 |
| 6 % PI 11 | > 170 | 110 |
| 3 % PI 12 | 30 | 20 |
| 6 % PI 12 | 100 | 60 |

**Patentansprüche**

1. Photopolymerisierbares Gemisch enthaltend
   A) mindestens eine ethylenisch ungesättigte photopolymerisierbare Verbindung,
   B) mindestens einen Photoinitiator der Formel I oder II

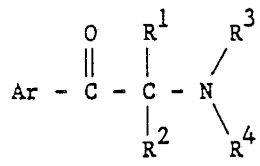
(I)

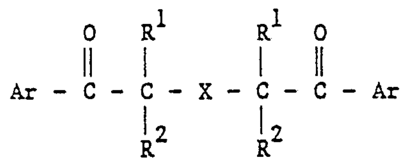
(II)

worin Ar eine unsubstituierte oder durch einen oder mehrere der Reste Halogen, $C_1$-$C_{12}$-Alkyl, $C_3$-$C_{12}$-Alkenyl, $C_5$-$C_6$-Cycloalkyl, $C_7$-$C_9$-Phenylalkyl, —COOH, —COO($C_1$-$C_4$-Alkyl), —$OR^5$, Methylendioxy, —SH, —$SR^6$, —SO—$R^6$, —$SO_2$—$R^6$, —CN, —$SO_2NH_2$, —$SO_2NH$($C_1$-$C_4$-Alkyl), —$SO_2$—N($C_1$-$C_4$-Alkyl$)_2$, —N($R^7$)($R^8$), —NHCO—$R^9$ oder durch eine Gruppe der Formel

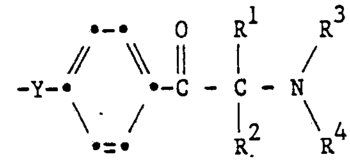

substituierte Phenyl-, Biphenylyl- oder Benzoylphenylgruppe oder eine Gruppe der Formeln III, IV oder V bedeutet,

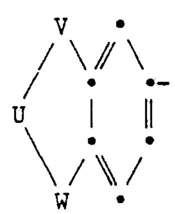
(III)

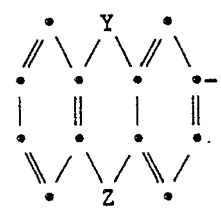
(IV)

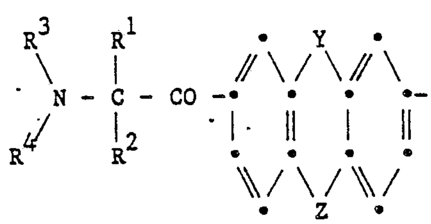
(V)

worin

U unverzweigtes oder verzweigtes $C_1$-$C_7$-Alkylen ist,

V eine direkte Bindung, —O—, —S— oder —N($R^{10}$)— bedeutet,

W eine direkte Bindung, —O—, —S— oder —N($R^{10}$)— bedeutet,

X einen zweiwertigen Rest der Formel

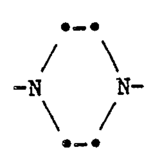
,

—N($R^{11}$)— oder —N($R^{11}$)—($CH_2)_m$—N($R^{11'}$)— mit m = 1-8 bedeutet,

Y eine direkte Bindung, —$CH_2$—, —$CH_2CH_2$—, —C—, —S—, —CO— oder —N($R^{10}$)— bedeutet,

Z eine direkte Bindung ist unter der Bedingung, dass Y nicht gleichzeitig eine direkte Bindung ist, oder —$CH_2$—, —$CH_2CH_2$—, —O—, —S—, —CO— oder —N($R^{10}$)— bedeutet,

$R^1$ und $R^2$ unabhängig voneinander $C_1$-$C_8$-Alkyl, durch OH, $C_1$-$C_4$-Alkoxy, —CN, —COO($C_1$-$C_8$-Alkyl), ($C_1$-$C_4$-Alkyl)—COO— oder —N($R^3$)($R^4$) substituiertes $C_1$-$C_4$-Alkyl, $C_3$-$C_6$-Alkenyl, Phenyl, Chlor-

phenyl, $R^5$—O-Phenyl, $R^6$—S-Phenyl oder $C_7$-$C_9$-Phenylalkyl bedeuten, oder $R^1$ und $R^2$ zusammen unverzweites oder verzweigtes $C_2$-$C_9$-Alkylen oder $C_3$-$C_9$-Oxa- oder Azaalkylen bedeuten,

$R^3$ und $R^4$ unabhängig voneinander Wasserstoff, $C_1$-$C_{12}$-Alkyl, durch eine oder mehrere der Gruppen OH, $C_1$-$C_4$-Alkoxy, —CN oder —COO($C_1$-$C_4$-Alkyl) substituiertes $C_2$-$C_4$-Alkyl, $C_3$-$C_5$-Alkenyl, Cyclohexyl, $C_7$-$C_9$-Phenylalkyl, Phenyl oder durch Cl, OH, $C_1$-$C_{12}$-Alkyl, $C_1$-$C_4$-Alkoxy oder —COO($C_1$-$C_4$-Alkyl) substituiertes Phenyl bedeuten oder $R^3$ und $R^4$ zusammen $C_3$-$C_7$-Alkylen bedeuten, das durch —O—, —S— oder —N($R^{12}$)— unterbrochen sein kann, oder $R^4$ zusammen mit $R^2$ $C_1$-$C_7$-Alkylen, $C_7$-$C_{10}$-Phenylalkylen, o-Xylylen oder $C_1$-$C_3$-Oxa- oder Azaalkylen bedeutet,

$R^5$ Wasserstoff, $C_1$-$C_{12}$-Alkyl, $C_3$-$C_{12}$-Alkenyl, Cyclohexyl, Hydroxycyclohexyl, durch einen oder mehrere der Reste Cl, Br, CN, SH, —N($C_1$-$C_4$-Alkyl)$_2$, Piperidino, Morpholino, OH, —O($C_1$-$C_4$-Alkyl), —$OCH_2CH_2CN$, $OCH_2CH_2COO$($C_1$-$C_4$-Alkyl), —OOC—$R^9$, —COOH, —COO($C_1$-$C_8$-Alkyl), —CONH($C_1$-$C_4$-Alkyl), —CON($C_1$-$C_4$-Alkyl)$_2$,

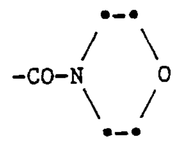,

—CO—($C_1$-$C_4$-Alkyl) oder —CO-Phenyl substituiertes $C_1$-$C_4$-Alkyl, 2,3-Epoxypropyl, —$(CH_2CH_2O)_n$—H mit n = 2-20, Phenyl, $C_7$-$C_9$-Phenylalkyl, durch Halogen, $C_1$-$C_4$-Alkyl, $C_1$-$C_4$-Alkoxy oder —COO($C_1$-$C_4$-Alkyl) substituiertes Phenyl, Tetrahydropyranyl Tetrahydrofuranyl, eine Gruppe —CO—$R^9$, —COO($C_1$-$C_8$-Alkyl), —CONH($C_1$-$C_4$-Alkyl), —CON($C_1$-$C_4$-Alkyl)$_2$, —Si($R^{13}$)($R^{14}$)$_2$ oder —$SO_2R^{15}$ bedeutet,

$R^6$ $C_1$-$C_{12}$-Alkyl, $C_3$-$C_{12}$-Alkenyl, Cyclohexyl, Hydroxycyclohexyl, durch eine oder mehrere der Gruppen Cl, Br, CN, SH, —N($C_1$-$C_4$-Alkyl)$_2$, Piperidino, Morpholino, —OH, —O($C_1$-$C_4$-Alkyl), —$OCH_2CH_2$—CN, —$OCH_2CH_2COO$($C_1$-$C_4$-Alkyl, —OOC—$R^9$, —COOH, —COO($C_1$-$C_8$-Alkyl), —CON($C_1$-$C_8$-Alkyl)$_2$,

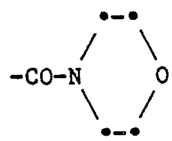,

—CO—($C_1$-$C_4$-Alkyl) oder —CO-Phenyl substituiertes $C_1$-$C_4$-Alkyl, 2,3-Epoxypropyl, Phenyl, $C_7$-$C_9$-Phenylalkyl, $C_7$-$C_9$-Phenylhydroxyalkyl, durch Halogen, $C_1$-$C_4$-Alkyl, $C_1$-$C_4$-Alkoxy oder —COO($C_1$-$C_4$-Alkyl) substituiertes Phenyl, 2-Benzthiazolyl, 2-Benzimidazolyl, —$CH_2CH_2$—O—$CH_2CH_2$—SH oder —$CH_2CH_2$—S—$CH_2CH_2$—SH bedeutet,

$R^7$ und $R^8$ unabhängig voneinander Wasserstoff, $C_1$-$C_{12}$-Alkyl, durch eine Gruppe —OH, $C_1$-$C_4$-Alkoxy, —CN oder —COO($C_1$-$C_4$-Alkyl) substituiertes $C_2$-$C_4$-Alkyl, $C_3$-$C_5$-Alkenyl, Cyclohexyl, $C_7$-$C_9$-Phenylalkyl, Phenyl oder durch eine oder mehrere der Gruppen $C_1$-$C_{12}$-Alkyl oder Halogen substituiertes Phenyl bedeuten, oder $R^7$ und $R^8$ zusammen $C_2$-$C_7$-Alkylen bedeuten, das durch —O—, —S— oder —N($R^{12}$)— unterbrochen sein kann,

$R^9$ $C_1$-$C_4$-Alkyl, $C_2$-$C_4$-Alkenyl oder Phenyl bedeutet,

$R^{10}$ Wasserstoff, $C_1$-$C_4$-Alkyl, Allyl, Benzyl oder $C_1$-$C_4$-Hydroxyalkyl bedeutet,

$R^{11}$ und $R^{11'}$ Wasserstoff, $C_1$-$C_9$-Alkyl, $C_1$-$C_4$-Hydroxyalkyl, Cyclohexyl oder Benzyl bedeuten,

$R^{12}$ Wasserstoff, $C_1$-$C_4$-Alkyl, Allyl, Benzyl, $C_1$-$C_4$-Hydroxyalkyl, —$CH_2CH_2CN$ oder —$CH_2CH_2$—COO($C_1$-$C_4$-Alkyl) bedeutet,

$R^{13}$ und $R^{14}$ $C_1$-$C_4$-Alkyl oder Phenyl bedeuten und

$R^{15}$ $C_1$-$C_{18}$-Alkyl, Phenyl oder $C_7$-$C_{20}$-Alkylphenyl bedeutet, und

C) einen Photosensibilisator aus der Gruppe der aromatischen Carbonylverbindungen mit einer Triplettenergie von 225-310 kJ/mol, wobei im Fall, dass B eine Verbindung der Formel I oder II ist, in der Ar einen Schwefel oder Sauerstoff enthaltenden Rest bedeutet, C kein Thioxanthonderivat ist.

2. Photopolymerisierbares Gemisch gemäss Anspruch 1, enthaltend als Komponente B) einen Photoinitiator der Formel I oder II, worin Ar eine unsubstituierte oder durch einen oder mehrere der Reste Halogen, $C_1$-$C_{12}$-Alkyl, $C_3$-$C_{12}$-Alkenyl, $C_5$-$C_6$-Cycloalkyl, $C_7$-$C_9$-Phenylalkyl, —COOH, —COO($C_1$-$C_4$-Alkyl), —$SO_2$—$R_6$, —CN, —$SO_2NH_2$, —$SO_2NH$($C_1$-$C_4$-Alkyl), —$SO_2$—N($C_1$-$C_4$-Alkyl)$_2$, —N($R_7$)($R_8$), —NHCO—$R_9$ oder durch eine Gruppe der Formel

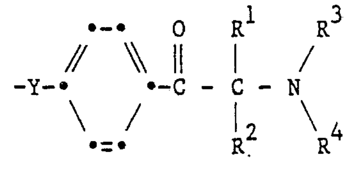

substituierte Phenyl-, Biphenylyl- oder Benzoylphenylgruppe bedeutet, Y eine direkte Bindung, $-CH_2-$, $-CH_2CH_2-$, $-CO-$ oder $-N(R^{10})-$ bedeutet und X, $R^1$, $R^2$, $R^3$, $R^4$, $R^6$, $R^7$, $R^8$, $R^9$ und $R^{10}$ die in Anspruch 1 gegebene Bedeutung haben.

3. Photopolymerisierbares Gemisch gemäss Anspruch 1, enthaltend als Komponente B) einen Photoinitiator der Formel I oder II, worin Ar eine unsubstituierte oder durch Chlor, $C_1$-$C_4$-Alkyl, Methylendioxy, $-OR^5$, $-SR^6$, $-N(R^7)(R^8)$ oder durch eine Gruppe der Formel

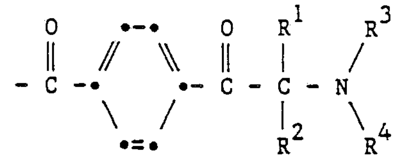

substituierte Phenyl- oder 4-Benzoylphenylgruppe bedeutet, X einen Rest der Formel

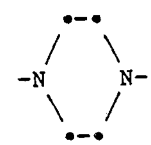

bedeutet, $R^1$ und $R^2$ unabhängig voneinander $C_1$-$C_4$-Alkyl, $-CH_2CH_2COO(C_1$-$C_4$-Alkyl), Allyl oder Benzyl bedeuten oder $R^1$ und $R^2$ zusammen unverzweigtes $C_4$-$C_5$-Alkylen bedeuten, $R^3$ und $R^4$ unabhängig voneinander $C_1$-$C_{12}$-Alkyl, durch OH, $C_1$-$C_4$-Alkoxy, CN oder $-COO(C_1$-$C_4$-Alkyl) substituiertes $C_2$-$C_4$-Alkyl, Allyl, Cyclohexyl oder Benzyl bedeuten, oder $R^3$ und $R^4$ zusammen $C_4$-$C_6$-Alkylen bedeuten, das durch $-O-$ oder $-N(R^{12})-$ unterbrochen sein kann, $R^5$ $C_1$-$C_4$-Alkyl, 2-Hydroxyethyl, 2,3-Epoxypropyl, Phenyl oder Benzyl bedeutet, $R^6$ $C_1$-$C_{12}$-Alkyl, Allyl, Cyclohexyl, durch OH, $-COO(C_1$-$C_8$-Alkyl) oder $-N(CH_3)_2$ substituiertes $C_1$-$C_4$-Alkyl, Benzyl, Phenyl, p-Tolyl oder $-CH_2CH_2OCH_2CH_2SH$ bedeutet, $R^7$ und $R^8$ unabhängig voneinander $C_1$-$C_4$-Alkyl, durch $-OH$, $C_1$-$C_4$-Alkoxy, $-CN$ oder $-COO(C_1$-$C_4$-Alkyl) substituiertes $C_2$-$C_4$-Alkyl, Cyclohexyl oder Allyl bedeuten oder $R^7$ und $R^8$ zusammen $C_4$-$C_6$-Alkylen bedeuten, das durch $-O-$ oder $-N(R^{12})-$ unterbrochen sein kann, und $R^{12}$ Wasserstoff, $C_1$-$C_4$-Alkyl oder $C_2$-$C_4$-Hydroxyalkyl bedeutet.

4. Photopolymerisierbares Gemisch gemäss Anspruch 1, enthaltend als Komponente B) einen Photoinitiator der Formel I, worin Ar einen unsubstituierten oder in 4-Stellung durch Chlor, Methyl, Methoxy, Methylthio, Di($C_1$-$C_4$-alkyl)amino- oder Morpholino substituierten Phenylrest, $R^1$ und $R^2$ $C_1$-$C_4$-Alkyl und $R^3$ und $R^4$ $C_1$-$C_4$-Alkyl oder 2-Methoxyethyl oder $R^3$ und $R^4$ zusammen mit dem N-Atom Morpholin bedeuten.

5. Photopolymerisierbares Gemisch gemäss Anspruch 1, enthaltend als Komponente C) ein Thioxanthon.

6. Photopolymerisierbares Gemisch gemäss Anspruch 1, enthaltend als Komponente C) ein 3-Acylcumarin.

7. Photopolymerisierbares Gemisch gemäss Anspruch 1, enthaltend als Komponente C) ein 2-(Aroylmethylen)-thiazolin.

8. Photopolymerisierbares Gemisch gemäss Anspruch 1, enthaltend als Komponente A) ein oder mehrere Acrylsäurederivat(e).

9. Photopolymerisierbares Gemisch gemäss Anspruch 1, enthaltend zusätzlich zu den Komponenten A), B) und C) noch weitere Bestandteile.

10. Verfahren zur Photopolymerisation von ethylenisch ungesättigten Verbindungen durch Bestrahlung mit kurzwelligem Licht in Gegenwart eines Photoinitiators und eines Photosensibilisators, dadurch gekennzeichnet, dass man als Photoinitiator eine Verbindung der Formel I oder II gemäss Anspruch 1 und als Photosensibilisator eine aromatische Carbonylverbindung mit einer Triplettenergie von 225-276 kJ/mol verwendet.

11. Eine Verbindung der Formel I oder II

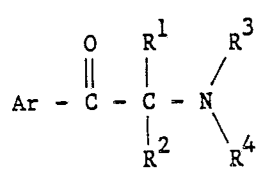

(I)

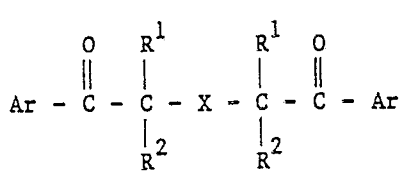

(II)

worin Ar eine durch einen oder mehrere der Reste Halogen, $C_1$-$C_{12}$-Alkyl, $C_3$-$C_{12}$-Alkenyl, $C_5$-$C_6$-Cycloalkyl, $C_7$-$C_9$-Phenylalkyl, —COOH, —COO($C_1$-$C_4$-Alkyl), —$OR^5$, Methylendioxy, —SH, —$SR^6$, —SO—$R^6$, —$SO_2$—$R^6$, —CN, —$SO_2NH_2$, —$SO_2NH$($C_1$-$C_4$-Alkyl), —$SO_2$—N($C_1$-$C_4$-Alkyl)$_2$, —N($R^7$)($R^8$), —NHCO—$R^9$ oder durch eine Gruppe der Formel

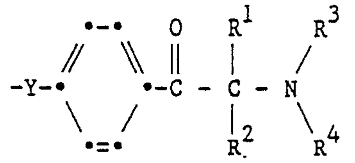

substituierte Phenyl-, Biphenylyl- oder Benzoylphenylgruppe bedeutet, wobei Ar mindestens einen Rest —N($R^7$)($R^8$) enthält und

X einen zweiwertigen Rest der Formel

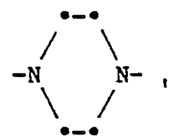

—N($R^{11}$)— oder —N($R^{11}$)—$(CH_2)_m$—N($R^{11'}$)— mit m = 1-8 bedeutet,

Y eine direkte Bindung, —$CH_2$—, —$CH_2CH_2$—, —O—, —S—, —CO— oder —N($R^{10}$)— bedeutet,

$R^1$ und $R^2$ unabhängig voneinander $C_1$-$C_8$-Alkyl, durch OH, $C_1$-$C_4$-Alkoxy, —CN, —COO($C_1$-$C_8$-Alkyl), ($C_1$-$C_4$-Alkyl)—COO— oder —N($R^3$)($R^4$) substituiertes $C_1$-$C_4$-Alkyl, $C_3$-$C_6$-Alkenyl, Phenyl, Chlorphenyl, $R^5$—O-Phenyl, $R^6$—S-Phenyl oder $C_7$-$C_9$-Phenylalkyl bedeuten, oder $R^1$ und $R^2$ zusammen unverzweigtes oder verzweigtes $C_2$-$C_9$-Alkylen oder $C_3$-$C_9$-Oxa- oder Azaalkylen bedeuten,

$R^3$ und $R^4$ unabhängig voneinander Wasserstoff, $C_1$-$C_{12}$-Alkyl, durch eine oder mehrere der Gruppen OH, $C_1$-$C_4$-Alkoxy, —CN oder —COO($C_1$-$C_4$-Alkyl) substituiertes $C_2$-$C_4$-Alkyl, $C_3$-$C_5$-Alkenyl, Cyclohexyl, $C_7$-$C_9$-Phenylalkyl, Phenyl oder durch Cl, OH, $C_1$-$C_{12}$-Alkyl, $C_1$-$C_4$-Alkoxy oder —COO($C_1$-$C_4$-Alkyl) substituiertes Phenyl bedeuten oder $R^3$ und $R^4$ zusammen $C_3$-$C_7$-Alkylen bedeuten, das durch —O—, —S— oder —N($R^{12}$)— unterbrochen sein kann, oder $R^4$ zusammen mit $R^2$ $C_1$-$C_7$-Alkylen, $C_7$-$C_{10}$-Phenylalkylen, o-Xylylen oder $C_1$-$C_3$-Oxa- oder Azaalkylen bedeutet,

$R^5$ Wasserstoff, $C_1$-$C_{12}$-Alkyl, $C_3$-$C_{12}$-Alkenyl, Cyclohexyl, Hydroxycyclohexyl, durch einen oder mehrere der Reste Cl, Br, CN, SH, —N($C_1$-$C_4$-Alkyl)$_2$, Piperidino, Morpholino, OH, —O($C_1$-$C_4$-Alkyl), —$OCH_2CH_2CN$, —$OCH_2CH_2COO$($C_1$-$C_4$-Alkyl), —OOC—$R^9$, —COOH, —COO($C_1$-$C_8$-Alkyl), —CONH($C_1$-$C_4$-Alkyl), —CON($C_1$-$C_4$-Alkyl)$_2$,

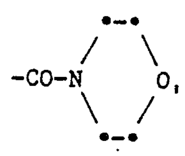

—CO—($C_1$-$C_4$-Alkyl) oder —CO-Phenyl substituiertes $C_1$-$C_4$-Alkyl, 2,3-Epoxypropyl, —$(CH_2CH_2O)_n$—H mit n = 2-20, Phenyl, $C_7$-$C_9$-Phenylalkyl, durch Halogen, $C_1$-$C_4$-Alkyl, $C_1$-$C_4$-Alkoxy oder —COO($C_1$-$C_4$-Alkyl) substituiertes Phenyl, Tetrahydropyranyl, Tetrahydrofuranyl, eine Gruppe —CO—$R^9$, —COO($C_1$-$C_8$-Alkyl), —CONH($C_1$-$C_4$-Alkyl), —CON($C_1$-$C_4$-Alkyl)$_2$, —Si($R^{13}$)($R^{14}$)$_2$ oder —$SO_2$—$R^{15}$ bedeutet,

$R^6$ $C_1$-$C_{12}$-Alkyl, $C_3$-$C_{12}$-Alkenyl, Cyclohexyl, Hydroxycyclohexyl, durch eine oder mehrere der Gruppen Cl, Br, CN, SH, —N($C_1$-$C_4$-Alkyl)$_2$, Piperidino, Morpholino, —OH, —O($C_1$-$C_4$-Alkyl), —$OCH_2CH_2$—CN, —$OCH_2CH_2COO$($C_1$-$C_4$-Alkyl), —OOC—$R^9$, —COOH, —COO($C_1$-$C_8$-Alkyl), —CON($C_1$-$C_8$-Alkyl)$_2$,

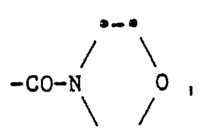

—CO—($C_1$-$C_4$-Alkyl) oder —CO-Phenyl substituiertes $C_1$-$C_4$-Alkyl, 2,3-Epoxypropyl, Phenyl, $C_7$-$C_9$-Phenylalkyl, $C_7$-$C_9$-Phenylhydroxyalkyl, durch Halogen, $C_1$-$C_4$-Alkyl, $C_1$-$C_4$-Alkoxy oder —COO($C_1$-$C_4$-Alkyl) substituiertes Phenyl, 2-Benzthiazolyl, 2-Benzimidazolyl, —$CH_2CH_2$—O—$CH_2CH_2$—SH oder —$CH_2CH_2$—S—$CH_2CH_2$—SH bedeutet,

$R^7$ und $R^8$ unabhängig voneinander Wasserstoff, $C_1$-$C_{12}$-Alkyl, durch eine Gruppe —OH, $C_1$-$C_4$-Alkoxy, —CN oder —COO($C_1$-$C_4$-Alkyl) substituiertes $C_2$-$C_4$-Alkyl, $C_3$-$C_5$-Alkenyl, Cyclohexyl, $C_7$-$C_9$-

Phenylalkyl, Phenyl oder durch eine oder mehrere der Gruppen $C_1$-$C_{12}$-Alkyl oder Halogen substituiertes Phenyl bedeuten, oder $R^7$ und $R^8$ zusammen $C_2$-$C_7$-Alkylen bedeuten, das durch —O—, —S— oder —N($R^{12}$)— unterbrochen sein kann,

$R^9$ $C_1$-$C_4$-Alkyl, $C_2$-$C_4$-Alkenyl oder Phenyl bedeutet,

$R^{11}$ und $R^{11'}$ Wasserstoff, $C_1$-$C_9$-Alkyl, $C_1$-$C_4$-Hydroxyalkyl, Cyclohexyl oder Benzyl bedeuten,

$R^{12}$ Wasserstoff, $C_1$-$C_4$-Alkyl, Allyl, Benzyl, $C_1$-$C_4$-Hydroxyalkyl, —$CH_2CH_2CN$ oder —$CH_2CH_2$—COO($C_1$-$C_4$-Alkyl) bedeutet,

$R^{13}$ und $R^{14}$ $C_1$-$C_4$-Alkyl oder Phenyl bedeuten und

$R^{15}$ $C_1$-$C_{18}$-Alkyl, Phenyl oder $C_7$-$C_{20}$-Alkylphenyl bedeutet.

12. Eine Verbindung gemäss Anspruch 11, worin Ar durch einen Rest —N($R^7$)($R^8$) substituiertes Phenyl, Alkylphenyl oder Halogenphenyl ist.

13. Eine Verbindung gemäss Anspruch 11, worin Ar eine durch einen Rest —N($R^7$)($R^8$) substituierte Phenylgruppe ist.

14. Eine Verbindung gemäss Anspruch 11, worin Ar eine in 4-Stellung durch Dialkylamino, Di(alkoxyalkyl)amino, Morpholino, Piperidino oder 4-Methylpiperazino substituierte Phenylgruppe ist.

15. Die Verbindung 2-Methyl-1-(4-dimethylaminophenyl)-2-dimethylamino-propanon-1 gemäss Anspruch 11.

16. Verwendung der Verbindungen gemäss Anspruch 11 als Photoinitiatoren für die Photopolymerisation ethylenisch ungesättigter Verbindungen.

17. Photopolymerisierbares Gemisch gemäss Anspruch 1, enthaltend als Komponente B) eine Verbindung des Anspruchs 11.

## Claims

1. Photopolymerisable mixture containing

A) at least one ethylenically unsaturated photopolymerisable compound,

B) at least one photoinitiator of the formula I or II

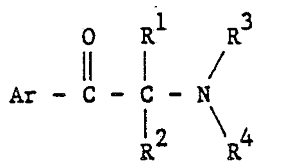

(I)

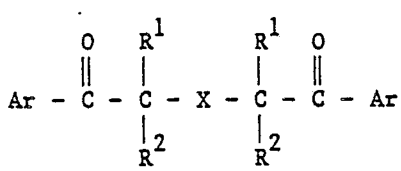

(II)

in which Ar is a phenyl, biphenylyl or benzoylphenyl group which is unsubstituted or substituted by one or more of the radicals halogen, $C_1$-$C_{12}$ alkyl, $C_3$-$C_{12}$ alkenyl, $C_5$-$C_6$ cycloalkyl, $C_7$-$C_9$ phenylalkyl, —COOH, —COO($C_1$-$C_4$ alkyl), —$CR^5$ methylenedioxy, —SH, —$SR^6$, —SO—$R^6$, —$SO_2$—$R^6$, —CN, —$SO_2NH_2$, —$SO_2NH$($C_1$-$C_4$ alkyl), —$SO_2$—N($C_1$-$C_4$ alkyl)$_2$, —N($R^7$)($R^8$) —NHCO—$R^9$ or by a group of the formula

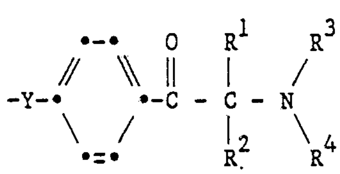

or is a group of the formula III, IV or V

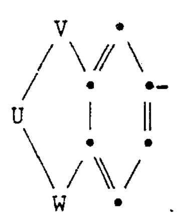

(III)

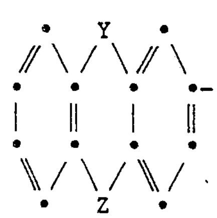

(IV)

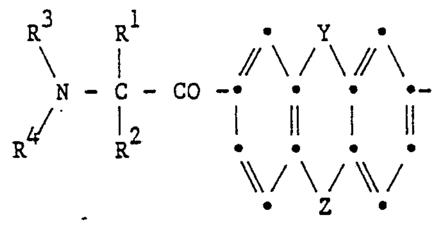

(V)

in which

U is unbranched or branched $C_1$-$C_7$-alkylene,

V is a direct bond, —O—, —S— or —N($R^{10}$)—,

W is a direct bond, —O—, —S— or —N($R^{10}$)—,

X is a divalent radical of the formulae

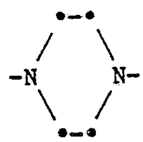,

—N($R^{11}$)— or —N($R^{11}$)—($CH_2$)$_m$—N($R^{11}$)— where m = 1-8,

Y is a direct bond, —$CH_2$—, —$CH_2CH_2$—, —O—, —S—, —CO— or —N($R^{10}$)—,

Z is a direct bond, provided Y is not a direct bond at the same time, or is —$CH_2$—, —$CH_2CH_2$—, —O—, —S—, —CO— or —N($R^{10}$)—,

$R^1$ and $R^2$, independently of each other, are each $C_1$-$C_8$ alkyl, OH—, $C_1$-$C_4$ alkoxy-, —CN—, —COO($C_1$-$C_8$ alkyl)-, ($C_1$-$C_4$ alkyl)—COO— or —N($R^3$) ($R^4$)-substituted $C_1$-$C_4$ alkyl, $C_3$-$C_6$ alkenyl, phenyl, chlorophenyl, $R^5$—O-phenyl, $R^6$—S-phenyl or $C_7$-$C_9$ phenylalkyl, or $R^1$ and $R^2$ together are unbranched or branched $C_2$-$C_9$ alkylene or $C_3$-$C_9$ oxaalkylene or -azaalkylene,

$R^3$ und $R^4$, independently of each other, are each hydrogen, $C_1$-$C_{12}$ alkyl, OH—, $C_1$-$C_4$ alkoxy-, —CN— or —COO($C_1$-$C_4$ alkyl) monosubstituted or -polysubstituted $C_2$-$C_4$ alkyl, $C_3$-$C_5$ alkenyl, cyclohexyl, $C_7$-$C_9$ phenylalkyl, phenyl or Cl—, OH—, $C_1$-$C_{12}$ alkyl-, $C_1$-$C_4$ alkoxy- or —COO($C_1$-$C_4$ alkyl)-substituted phenyl, or $R^3$ and $R^4$ together are $C_3$-$C_7$ alkylene which can be interrupted by —O—, —S— or —N($R^{12}$)—, or $R^4$, together with $R^2$, is $C_1$-$C_7$ alkylene, $C_7$-$C_{10}$ phenylalkylene, o-xylylene or $C_1$-$C_3$ oxaalkylene or -azaalkylene,

$R^5$ is hydrogen, $C_1$-$C_{12}$ alkyl, $C_3$-$C_{12}$ alkenyl, cyclohexyl, hydroxycyclohexyl, Cl—, Br—, CN—, SH—, —N($C_1$-$C_4$ alkyl)$_2$—, piperidino-, morpholino-, OH—, —O($C_1$-$C_4$ alkyl)-, —$OCH_2CH_2CN$—, —$OCH_2CH_2COO$($C_1$-$C_4$ alkyl)-, —OOC—$R^9$—, —COOH—, —COO($C_1$-$C_8$ alkyl)-, —CONH($C_1$-$C_4$ alkyl)-, —CON($C_1$-$C_4$ alkyl)$_2$—,

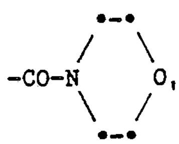,

—CO—($C_1$-$C_4$ alkyl)- or —CO-phenyl-monosubstituted or -polysubstituted $C_1$-$C_4$ alkyl, 2,3-epoxypropyl, —($CH_2CH_2O$)$_n$—H where n = 2-20, phenyl, $C_7$-$C_9$ phenylalkyl, halogen-, $C_1$-$C_4$ alkyl-, $C_1$-$C_4$ alkoxy- or —COO($C_1$-$C_4$ alkyl)-substituted phenyl, tetrahydropyranyl, tetrahydrofuranyl, a group of the formula —CO—$R^9$, —COO($C_1$-$C_8$ alkyl), —CONH($C_1$-$C_4$ alkyl), —CON($C_1$-$C_4$ alkyl)$_2$, —Si($R^{13}$)($R^{14}$)$_2$ or —$SO_2$—$R^{15}$,

$R^6$ is $C_1$-$C_{12}$ alkyl, $C_3$-$C_{12}$ alkenyl, cyclohexyl, hydroxycyclohexyl, Cl—, Br—, CN—, SH—, —N($C_1$-$C_4$ alkyl)$_2$—, piperidino-, morpholino-, —OH—, —O($C_1$-$C_4$ alkyl)-, —$OCH_2CH_2$—CN—, —$OCH_2CH_2COO$($C_1$-$C_4$ alkyl)-, —OOC—$R^9$—, —COOH—, —COO($C_1$-$C_8$ alkyl)-, —CON($C_1$-$C_8$ alkyl)$_2$—,

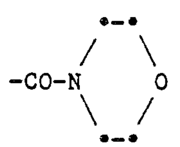,

—CO—($C_1$-$C_4$ alkyl)- or —CO-phenyl-monosubstituted or -polysubstituted $C_1$-$C_4$ alkyl, 2,3-epoxypropyl, phenyl, $C_7$-$C_9$ phenylalkyl, $C_7$-$C_9$ phenylhydroxyalkyl, halogen-, $C_1$-$C_4$ alkyl-, $C_1$-$C_4$ alkoxy- or —COO($C_1$-$C_4$ alkyl)-substituted phenyl, 2-benzothiazolyl, 2-benzimidazolyl, —$CH_2CH_2$—O—$CH_2CH_2$—SH or —$CH_2CH_2$—S—$CH_2CH_2$—SH,

$R^7$ and $R^8$, independently of each other, are each hydrogen, $C_1$-$C_{12}$ alkyl, —OH—, $C_1$-$C_4$ alkoxy-, —CN— or —COO($C_1$-$C_4$ alkyl)- monosubstituted $C_2$-$C_4$ alkyl, $C_3$-$C_5$ alkenyl, cyclohexyl, $C_7$-$C_9$ phenylalkyl, phenyl or $C_1$-$C_{12}$ alkyl- or halogen-monosubstituted or -polysubstituted phenyl, or $R^7$ and $R^8$ together are $C_2$-$C_7$ alkylene which can be interrupted by —O—, —S— or —N($R^{12}$)—,

$R^9$ is $C_1$-$C_4$ alkyl, $C_2$-$C_4$ alkenyl or phenyl,

$R^{10}$ is hydrogen, $C_1$-$C_4$ alkyl, allyl, benzyl or $C_1$-$C_4$ hydroxyalkyl,

$R^{11}$ and $R^{11'}$ are each hydrogen, $C_1$-$C_9$ alkyl, $C_1$-$C_4$ hydroxyalkyl, cyclohexyl or benzyl,

$R^{12}$ is hydrogen, $C_1$-$C_4$ alkyl, allyl, benzyl, $C_1$-$C_4$ hydroxyalkyl, —$CH_2CH_2CN$ or —$CH_2CH_2$—COO($C_1$-$C_4$ alkyl),

$R^{13}$ and $R^{14}$ are each $C_1$-$C_4$ alkyl or phenyl and

$R^{15}$ is $C_1$-$C_{18}$ alkyl, phenyl or $C_7$-$C_{20}$ alkylphenyl, and

C) a photosensitiser from the group of aromatic carbonyl compounds having a triplet energy of 225-310 kJ/mol, where, if B is a compound of the formula I or II in which Ar is a sulfur- or oxygen-containing radical, C is not a thioxanthone derivative.

2. Photopolymerisable mixture according to Claim 1 containing as component B) a photoinitiator of the formula I or II in which Ar is a phenyl, biphenylyl or benzoylphenyl group which is unsubstituted or substituted by one or more of the radicals halogen, $C_1$-$C_{12}$ alkyl, $C_3$-$C_{12}$ alkenyl, $C_5$-$C_6$ cycloalkyl, $C_7$-$C_9$ phenylalkyl, —COOH, —COO($C_1$-$C_4$ alkyl), —$SO_2$—$R^6$ [sic] —CN, —$SO_2NH_2$, —$SO_2NH$($C_1$-$C_4$ alkyl), —$SO_2$—N($C_1$-$C_4$ alkyl)$_2$, —N($R_7$)($R_8$) [sic] or —NHCO—$R_9$ [sic] or by a group of the formula

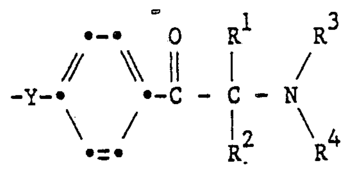

Y is a direct bond, —$CH_2$—, —$CH_2CH_2$—, —CO— or —N($R^{10}$)—, and X, $R^1$, $R^2$, $R^3$, $R^4$, $R^6$, $R^7$, $R^8$, $R^9$ and $R^{10}$ are as defined in claim 1.

3. Photopolymerisable mixture according to Claim 1 containing as component B) a photoinitiator of the formula I or II in which Ar is a phenyl or 4-benzoylphenyl group which is unsubstituted or substituted by chlorine, $C_1$-$C_4$ alkyl, methylenedioxy, —$OR^5$, —$SR^6$ or —N($R^7$)($R^8$) or by a group of the formula

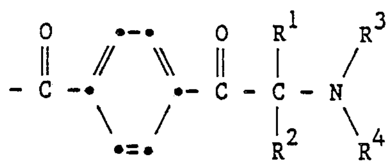

X is a radical of the formula

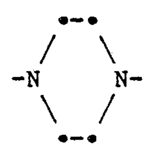

$R^1$ and $R^2$, independently of each other, are each $C_1$-$C_4$ alkyl, —$CH_2CH_2COO$ ($C_1$-$C_4$ alkyl), allyl or benzyl or $R^1$ and $R^2$ together are unbranched $C_4$-$C_5$ alkylene, $R^3$ and $R^4$, independently of each other, are each $C_1$-$C_{12}$ alkyl, OH—, $C_1$-$C_4$ alkoxy-, CN— or —COO($C_1$-$C_4$ alkyl)-substituted $C_2$-$C_4$ alkyl, allyl, cyclohexyl or benzyl, or $R^3$ and $R^4$ together are $C_4$-$C_6$ alkylene which can be interrupted by —O— or —N($R^{12}$)—, $R^5$ is $C_1$-$C_4$ alkyl, 2-hydroxyethyl, 2,3-epoxypropyl, phenyl or benzyl, $R^6$ is $C_1$-$C_{12}$ alkyl, allyl, cyclohexyl, OH—, —COO($C_1$-$C_8$-alkyl)- or —N($CH_3$)$_2$-substituted $C_1$-$C_4$ alkyl, benzyl, phenyl, p-tolyl or —$CH_2CH_2OCH_2CH_2SH$, $R^7$ and $R^8$, independently of each other, are each $C_1$-$C_4$ alkyl, —OH—, $C_1$-$C_4$ alkoxy-, —CN— or —COO($C_1$-$C_4$ alkyl)-substituted $C_2$-$C_4$ alkyl, cyclohexyl or allyl, or $R^7$ and $R^8$ together are $C_4$-$C_6$ alkylene which can be interrupted by —O— or —N($R^{12}$)—, and $R^{12}$ is hydrogen, $C_1$-$C_4$ alkyl or $C_2$-$C_4$ hydroxyalkyl.

4. Photopolymerisable mixture according to Claim 1 containing as component B) a photoinitiator of the formula I in which Ar is a phenyl radical which is unsubstituted or substituted in the 4-position by chlorine, methyl, methoxy, methylthio, di($C_1$-$C_4$ alkylamino) or morpholino, $R^1$ and $R^2$ are each $C_1$-$C_4$ alkyl and $R^3$ and $R^4$ are each $C_1$-$C_4$ alkyl or 2-methoxyethyl or $R^3$ and $R^4$ together with the N atom are morpholine.

5. Photopolymerisable mixture according to Claim 1 containing as component C) a thioxanthone.

6. Photopolymerisable mixture according to Claim 1 containing as component C) a 3-acylcoumarin.

7. Photopolymerisable mixture according to Claim 1 containing as component C) a 2-(aroylmethylene)-thiazoline.

8. Photopolymerisable mixture according to Claim 1 containing as component A) one or more acrylic acid derivatives.

9. Photopolymerisable mixture according to Claim 1 containing further components in addition to components A) B) and C).

10. Process for photopolymerising ethylenically unsaturated compounds by irradiation with shortwave light in the presence of a photoinitiator and a photosensitiser, which comprises using as the photoinitiator a compound of the formula I or II according to claim 1 and as the photosensitiser an aromatic carbonyl compound having a triplet energy of 225-276 kJ/mol.

11. A compound of the formula I or II

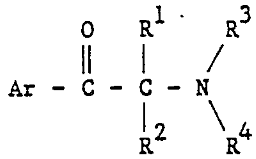

(I)

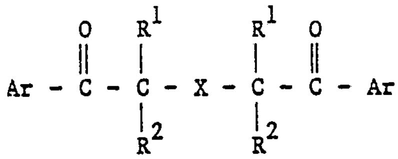

(II)

in which Ar is a phenyl, biphenylyl or benzoylphenyl group which is unsubstituted or substituted by one or more of the radicals halogen, $C_1$-$C_{12}$ alkyl, $C_3$-$C_{12}$ alkenyl, $C_5$-$C_6$ cycloalkyl, $C_7$-$C_9$ phenylalkyl, —COOH, —COO($C_1$-$C_4$ alkyl), —$OR^5$, methylenedioxy, —SH, —$SR^6$, —SO—$R^6$, —$SO_2$-$R^6$, —CN, —$SO_2NH_2$, $SO_2NH$($C_1$-$C_4$ alkyl), —$SO_2$—N($C_1$-$C_4$ alkyl)$_2$, —N($R^7$)($R^8$), —NHCO—$R^9$ or by a group of the formula

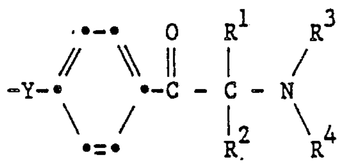

in which Ar contains at least one —N($R^7$)($R^8$) and

radical X is a divalent radical of the formulae

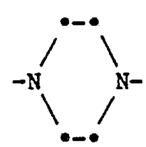

—N($R^{11}$)— or —N($R^{11}$)—$(CH_2)_m$—N($R^{11'}$)— where m = 1-8,

Y is a direct bond, —$CH_2$—, —$CH_2CH_2$—, —O—, —S—, —CO— or —N($R^{10}$)—,

$R^1$ and $R^2$, independently of each other, are each $C_1$-$C_8$ alkyl, OH—, $C_1$-$C_4$ alkoxy-, —CN—, —COO($C_1$-$C_8$ alkyl)-, ($C_1$-$C_4$ alkyl)—COO— or —N($R^3$)($R^4$)-substituted $C_1$-$C_4$ alkyl, $C_3$-$C_6$ alkenyl, phenyl, chlorophenyl, $R^5$—O-phenyl, $R^6$—S-phenyl or $C_7$-$C_9$ phenylalkyl, or $R^1$ and $R^2$ together are unbranched or branched $C_2$-$C_9$ alkylene or $C_3$-$C_9$ oxaalkylene or -azaalkylene,

$R^3$ and $R^4$, independently of each other, are each hydrogen, $C_1$-$C_{12}$ alkyl, OH—, $C_1$-$C_4$ alkoxy-, —CN— or —COO($C_1$-$C_4$ alkyl)-monosubstituted or -polysubstituted $C_2$-$C_4$ alkyl, $C_3$-$C_5$ alkenyl, cyclohexyl, $C_7$-$C_9$ phenylalkyl, phenyl or Cl—, OH—, $C_1$-$C_{12}$ alkyl, $C_1$-$C_4$ alkoxy or —COO($C_1$-$C_4$ alkyl)-substituted phenyl, or $R^3$ and $R^4$ together are $C_3$-$C_7$ alkylene which can be interrupted by —O—, —S— or —N($R^{12}$)—, or $R^4$, together with $R^2$, is $C_1$-$C_7$ alkylene, $C_7$-$C_{10}$ phenylalkylene, o-xylylene or $C_1$-$C_3$ oxaalkylene or azaalkylene,

$R^5$ is hydrogen, $C_1$-$C_{12}$ alkyl, $C_3$-$C_{12}$ alkenyl, cyclohexyl, hydroxycyclohexyl, Cl—, Br—, CN—, SH—, —N($C_1$-$C_4$ alkyl)$_2$—, piperidino-, morpholino-, OH—, —O($C_1$-$C_4$ alkyl)-, —$OCH_2CH_2CN$—, —$OCH_2CH_2COO$($C_1$-$C_4$ alkyl)-, —OOC—$R^9$—, —COOH—, —COO($C_1$-$C_8$ alkyl)-, —CONH($C_1$-$C_4$ alkyl)-, —CON($C_1$-$C_4$ alkyl)$_2$—,

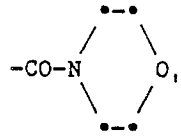

—, —CO—($C_1$-$C_4$ alkyl)- or —CO-phenyl-monosubstituted or -polysubstituted $C_1$-$C_4$ alkyl, 2,3-epoxypropyl, —$(CH_2CH_2O)_n$—H where n = 2-20, phenyl, $C_7$-$C_9$ phenylalkyl, halogen-, $C_1$-$C_4$ alkyl-, $C_1$-$C_4$ alkoxy- or —COO($C_1$-$C_4$ alkyl)-substituted phenyl, tetrahydropyranyl, tetrahydrofuranyl, a group of the formula —CO—$R^9$, —COO($C_1$-$C_8$ alkyl), —CONH($C_1$-$C_4$ alkyl), —CON($C_1$-$C_4$-alkyl)$_2$, —Si($R^{13}$)($R^{14}$)$_2$ or —$SO_2$—$R^{15}$,

$R^6$ is $C_1$-$C_{12}$ alkyl, $C_3$-$C_{12}$ alkenyl, cyclohexyl, hydroxycyclohexyl, Cl—, Br— CN—, SH—, (N($C_1$-$C_4$ alkyl)$_2$—, piperidino-, morpholino-, —OH—, —O($C_1$-$C_4$ alkyl)-, —$OCH_2CH_2$—CN—, —$OCH_2CH_2COO$($C_1$-$C_4$ alkyl)-, —OOC—$R^9$—, —COOH—, —COO($C_1$-$C_8$ alkyl)-, —CON($C_1$-$C_8$ alkyl)$_2$—,

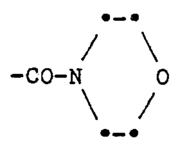 ,

—, —CO—($C_1$-$C_4$ alkyl)- or —CO-phenyl-monosubstituted or -polysubstituted $C_1$-$C_4$ alkyl, 2,3-epoxypropyl, phenyl, $C_7$-$C_9$ phenylalkyl, $C_7$-$C_9$ phenylhydroxyalkyl, halogen-, $C_1$-$C_4$ alkyl-, $C_1$-$C_4$ alkoxy- or —COO($C_1$-$C_4$ alkyl)-substituted phenyl, 2-benzothiazolyl, 2-benzimidazolyl, —$CH_2CH_2$—O—$CH_2CH_2$—SH or —$CH_2CH_2$—S—$CH_2CH_2$—SH,

$R^7$ and $R^8$, independently of each other, are each hydrogen, $C_1$-$C_{12}$ alkyl, —OH—, $C_1$-$C_4$ alkoxy-, —CN— or —COO($C_1$-$C_4$ alkyl) monosubstituted $C_2$-$C_4$ alkyl, $C_3$-$C_5$ alkenyl, cyclohexyl, $C_7$-$C_9$ phenylalkyl, phenyl or $C_1$-$C_{12}$ alkyl- or halogen-monosubstituted or -polysubstituted phenyl, or $R^7$ and $R^8$ together are $C_2$-$C_7$ alkylene which can be interrupted by —O—, —S— or —N($R^{12}$)—,

$R^9$ is $C_1$-$C_4$ alkyl, $C_2$-$C_4$ alkenyl or phenyl,

[lacuna] $R^{11}$ and $R^{11'}$ are each hydrogen, $C_1$-$C_9$ alkyl, $C_1$-$C_4$ hydroxyalkyl, cyclohexyl or benzyl,

$R^{12}$ is hydrogen, $C_1$-$C_4$ alkyl, allyl, benzyl, $C_1$-$C_4$ hydroxyalkyl, —$CH_2CH_2CN$ or —$CH_2CH_2$—COO($C_1$-$C_4$ alkyl),

$R^{13}$ and $R^{14}$ are each $C_1$-$C_4$ alkyl or phenyl and

$R^{15}$ is $C_1$-$C_{18}$ alkyl, phenyl or $C_7$-$C_{20}$ alkylphenyl.

12. A compound according to Claim 11, in which Ar is a —N($R^7$)($R^8$)-substituted phenyl, alkylphenyl or halogenophenyl.

13. A compound according to Claim 11, in which Ar is a —N($R^7$)($R^8$)-substituted phenyl group.

14. A compound according to Claim 11, in which Ar is a phenyl group which is substituted in the 4-position by dialkylamino, di(alkoxyalkyl)amino, morpholino, piperidino or 4-methylpiperazino.

15. The compound 2-methyl-1-(4-dimethylaminophenyl)-2-dimethylaminopropan-1-one according to Claim 11.

16. Use of compounds according to Claim 11 as photoinitiators for photopolymerising ethylenically unsaturated compounds.

17. Photopolymerisable mixture according to Claim 11 containing as component B) a compound of claim 12.

**Revendications**

1. Mélange photopolymérisable contenant :

A) un ou plusieurs composés photopolymérisables à insaturation éthylénique,

B) un ou plusieurs photoinducteurs de formule I ou II ci-dessous :

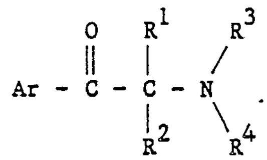 (I)

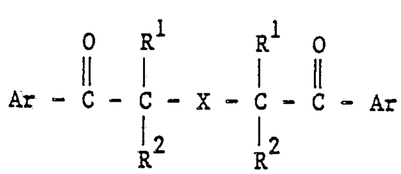 (II)

formules dans lesquelles Ar représente un groupe phényle, biphénylyle ou benzoylphényle sans substituants ou avec un ou plusieurs atomes d'halogènes, alkyles en $C_1$-$C_{12}$, alcényles en $C_3$-$C_{12}$, cycloalkyles en $C_5$-$C_6$, phénylalkyles en $C_7$-$C_9$, groupes —COOH, —COO($C_1$-$C_4$-alkyles, —$OR^5$, méthylè-

ne-dioxy, —SH, —$SR^6$, —SO—$R^6$, —$SO_2$-$R^6$, —CN, —$SO_2NH_2$, —$SO_2NH(C_1$-$C_4$-alkyles), —$SO_2$-N($C_1$-$C_4$-alkyles$)_2$, —N($R^7$) ($R^8$), —NHCO—$R^9$ ou un groupe de formule :

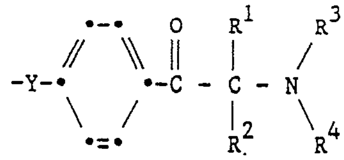

ou un groupe de formule III, IV ou V :

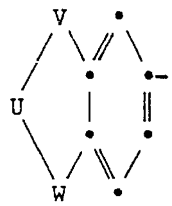
(III)

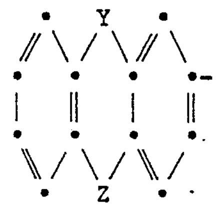
(IV)

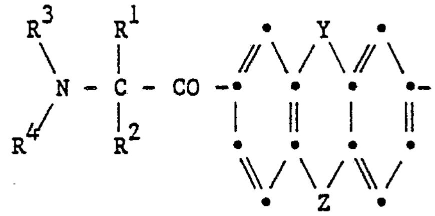
(V)

dans lesquelles :

U représente un alkylène en $C_1$-$C_7$ linéaire ou ramifié,

V une liaison directe, —O—, —S— ou —N($R^{10}$)—,

W une liaison directe, —O—, —S— ou —N($R^{10}$)—,

X un radical divalent de formule :

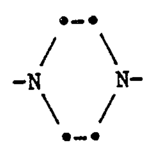

—N($R^{11}$)— ou —N($R^{11}$)—$(CH_2)_m$—N($R^{11'}$)—, m étant un nombre de 1 à 8,

Y une liaison directe, —$CH_2$—, —$CH_2CH_2$—, —O—, —S—, —CO— ou —N($R^{10}$)—,

Z une liaison directe, avec la condition que Y ne représente pas aussi une liaison directe, ou —$CH_2$—, —$CH_2CH_2$—, —O—, —S—, —CO— ou —N($R^{10}$)—,

$R^1$ et $R^2$ représentent chacun, indépendamment l'un de.l'autre, un alkyle en $C_1$-$C_8$, un alkyle en $C_1$-$C_4$ avec un groupe OH, alcoxy en $C_1$-$C_4$, —CN, —COO($C_1$-$C_8$-alkyle), ($C_1$-$C_4$-alkyle)—COO— ou —N($R^3$)($R^4$) ou un groupe alcényle en $C_3$-$C_6$, phényle, chlorophényle, $R^5$—O—phényle, $R^6$—S—phényle ou phénylalkyle en $C_2$-$C_9$, ou bien $R^1$ et $R^2$ forment ensemble un alkylène en $C_2$-$C_9$ linéaire ou ramifié ou un groupe oxa- ou aza-alkylène en $C_3$-$C_9$,

$R^3$ et $R^4$ représentent chacun, indépendamment l'un de l'autre, l'hydrogène, un alkyle en $C_1$-$C_{12}$, un alkyle en $C_2$-$C_4$ avec un ou plusieurs groupes —OH, alcoxy en $C_1$-$C_4$, —CN ou —COO($C_1$-$C_4$-alkyles), un alcényle en $C_3$-$C_5$ ou un groupe cyclohexyle, phénylalkyle en $C_7$-$C_9$, ou un phényle éventuellement substitué par du chlore ou un groupe OH, alkyle en $C_1$-$C_{12}$, alcoxy en $C_1$-$C_4$ ou —COO($C_1$-$C_4$-alkyle), ou bien $R^3$ et $R^4$ forment ensemble un alkylène en $C_3$-$C_7$ pouvant être interrompu par —O—, —S— ou un groupe —N($R^{12}$)—, ou encore $R^4$ forme avec $R^2$ un groupe alkylène en $C_1$-$C_7$, phénylalkylène en $C_7$-$C_{10}$, o-xylylène ou oxa- ou aza-alkylène en $C_1$-$C_3$,

$R^5$ représente l'hydrogène, un alkyle en $C_1$-$C_{12}$, un alcényle en $C_3$-$C_{12}$, un cyclohexyle, un hydroxycyclohexyle, un alkyle en $C_1$-$C_4$ avec un ou plusieurs atomes de chlore ou de brome ou groupes CN, SH, —N($C_1$-$C_4$-alkyles$)_2$, pipéridino, morpholino, OH, —O($C_1$-$C_4$-alkyles), —$OCH_2CH_2CN$, —$OCH_2CH_2COO$($C_1$-$C_4$-alkyles), —OOC-$R^9$, —COOH, —COO($C_1$-$C_8$-alkyles), —CONH($C_1$-$C_4$-alkyles), —CON($C_1$-$C_4$-alkyles$)_2$,

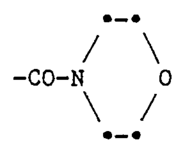

—CO—($C_1$-$C_4$-alkyles) ou —CO—phényles, un groupe 2,3-époxypropyle, —$(CH_2—CH_2O)_n$—H, n étant un nombre de 2 à 20, phényle, phénylalkyle en $C_7$-$C_9$ ou phényle portant un halogène ou un alkyle en $C_1$-$C_4$, un alcoxy en $C_1$-$C_4$ ou un groupe —COO($C_1$-$C_4$-alkyle), tétrahydropyrannyle, tétrahydrofurannyle, ou encore un groupe —CO—$R^9$, —COO($C_1$-$C_8$-alkyle), —CONH($C_1$-$C_4$-alkyle), —CON($C_1$-$C_4$-alkyle)$_2$, —Si($R^{13}$) $(R^{14})_2$ ou —$SO_2$—$R^{15}$,

$R^6$ désigne un alkyle en $C_1$-$C_{12}$, un alcényle en $C_3$-$C_{12}$, un cyclohexyle ou un hydroxycyclohexyle ou un alkyle en $C_1$-$C_4$ avec un ou plusieurs atomes de chlore ou de brome ou groupes CN, —SH, —N($C_1$-$C_4$-alkyles)$_2$, pipéridino, morpholino, —OH, —O($C_1$-$C_8$-alkyles), —$OCH_2CH_2$—CN, —$OCH_2CH_2COO$($C_1$-$C_4$-alkyles), —OOC—$R^9$, —COOH, —COO($C_1$-$C_8$-alkyles), —CON($C_1$-$C_8$-alkyles)$_2$,

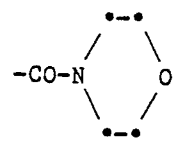

—CO—($C_1$-$C_4$-alkyles) ou —CO—phényles, un groupe 2,3-époxypropyle, phényle, phénylalkyle en $C_7$-$C_9$, phénylhydroxyalkyle en $C_7$-$C_9$, un phényle portant un halogène, un alkyle en $C_1$-$C_4$, un alcoxy en $C_1$-$C_4$ ou un groupe —COO($C_1$-$C_4$-alkyle), ou un groupe 2-benzothiazolyle, 2-benzimidazolyle, —$CH_2CH_2$—O—$CH_2CH_2$—SH ou —$CH_2CH_2$—S—$CH_2CH_2$—SH,

$R^7$ et $R^8$ représentent chacun, indépendamment l'un de l'autre, un alkyle en $C_1$-$C_{12}$, un alkyle en $C_2$-$C_4$ avec un groupe —OH, alcoxy en $C_1$-$C_4$, —CN ou —COO($C_1$-$C_4$-alkyle), un alcényle en $C_3$-$C_5$, un cyclohexyle, un phénylalkyle en $C_7$-$C_9$ ou un phényle pouvant porter éventuellement un ou plusieurs alkyles en $C_1$-$C_{12}$ ou atomes d'halogènes, ou bien $R^7$ et $R^8$ forment ensemble un alkylène en $C_2$-$C_7$ pouvant être interrompu par —O—, —S— ou —N($R^{12}$)—,

$R^9$ désigne un alkyle en $C_1$-$C_4$, un alcényle en $C_2$-$C_4$ ou un phényle,

$R^{10}$ l'hydrogène, un alkyle en $C_1$-$C_4$ ou un allyle, benzyle ou hydroxyalkyle en $C_1$-$C_4$,

$R^{11}$ et $R^{11'}$ désignent chacun l'hydrogène, un alkyle en $C_1$-$C_9$, un hydroxyalkyle en $C_1$-$C_4$, un cyclohexyle ou un benzyle,

$R^{12}$ désigne l'hydrogène, un alkyle en $C_1$-$C_4$ ou un groupe allyle, benzyle, hydroxyalkyle en $C_1$-$C_4$, —$CH_2CH_2CN$ ou —$CH_2CH_2$—COO($C_1$-$C_4$-alkyle),

$R^{13}$ et $R^{14}$ sont chacun un alkyle en $C_1$-$C_4$ ou un phényle, et

$R^{15}$ est un alkyle en $C_1$-$C_{18}$, un phényle ou un alkylphényle en $C_7$-$C_{20}$, et

C) un photosensibilisateur du groupe des composés carbonyliques aromatiques ayant une énergie de triplet de 225 à 310 kJ/mole, et si le composé B est un composé de formule I ou II dans lequel Ar est un radical aromatique avec du soufre ou de l'oxygène, ce photosensibilisateur C n'est pas un dérivé de la thioxanthone.

2. Mélange photopolymérisable selon la revendication 1, qui contient comme composante B) un photoinducteur de formule I ou II dans lequel Ar est un radical phényle, biphénylyle ou benzoylphényle sans substituants ou portant un ou plusieurs atomes d'halogènes ou groupes alkyles en $C_1$-$C_{12}$, alcényles en $C_3$-$C_{12}$, cycloalkyles en $C_5$-$C_6$, phénylalkyles en $C_7$-$C_9$, —COOH, —COO($C_1$-$C_4$-alkyles), —$SO_2$—$R^6$, —CN, —$SO_2NH$, —$SO_2NH$($C_1$-$C_4$-alkyles), —$SO_2$—N($C_1$-$C_4$-alkyles)$_2$, —N($R^7$) ($R^8$), —NHCO—$R^9$ ou un groupe de formule :

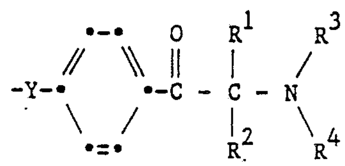

Y représentant une liaison directe ou un groupe —$CH_2$—, —$CH_2CH_2$—, —CO— ou —N($R^{10}$)—, et X, $R^1$, $R^2$, $R^3$, $R^4$, $R^6$, $R^7$, $R^8$, $R^9$ et $R^{10}$ ayant les significations données à la revendication 1.

3. Mélange photopolymérisable selon la revendication 1 qui contient comme composante B) un photoinducteur de formule I ou II dans lequel Ar est un radical phényle ou 4-benzoylphényle sans substituants ou substitué par du chlore, en alkyle en $C_1$-$C_4$, un groupe méthylène-dioxy, —$OR^5$, —$SR^6$, —N($R^7$) ($R^8$) ou par un groupe de formule :

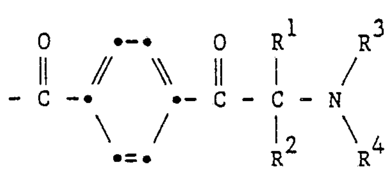

X représente un radical

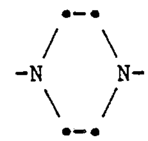

$R^1$ et $R^2$ désignent chacun, indépendamment l'un de l'autre, un alkyle en $C_1$-$C_4$ ou un groupe $—CH_2CH_2COO(C_1$-$C_4$-alkyle), allyle ou benzyle, ou bien forment ensemble un alkylène en $C_4$-$C_5$ non ramifié, $R^3$ et $R^4$ désignent chacun, indépendamment l'un de l'autre, un alkyle en $C_1$-$C_{12}$, un alkyle en $C_2$-$C_4$ substitué par un groupe OH, alcoxy en $C_1$-$C_4$, CN ou $—COO(C_1$-$C_4$-alkyle), ou encore un groupe allyle, cyclohexyle ou benzyle, ou bien $R^3$ et $R^4$ forment ensemble un alkylène en $C_4$-$C_6$ pouvant être interrompu par un atome d'oxygène ou un groupe $—N(R^{12})—$, $R^5$ est un groupe alkyle en $C_1$-$C_4$, 2-hydroxyéthyle, 2,3-époxypropyle, phényle ou benzyle, $R^6$ un alkyle en $C_1$-$C_{12}$, un groupe allyle ou cyclohexyle, un alkyle en $C_1$-$C_4$ substitué par un groupe —OH, $—COO(C_1$-$C_8$-alkyle) ou $—N(CH_3)_2$ ou encore un groupe benzyle, phényle, p-tolyle ou $—CH_2CH_2OCH_2CH_2SH$, $R^7$ et $R^8$ représentent chacun, indépendamment l'un de l'autre, un alkyle en $C_1$-$C_4$ ou un alkyle en $C_2$-$C_4$ substitué par un groupe —OH, alcoxy en $C_1$-$C_4$, —CN ou $—COO(C_1$-$C_4$-alkyle), ou un groupe cyclohexyle ou allyle, ou bien forment ensemble un alkylène en $C_4$-$C_6$ pouvant être interrompu par un atome d'oxygène ou un groupe $—N(R^{12})—$, et $R^{12}$ représente l'hydrogène, un alkyle en $C_1$-$C_4$ ou un hydroxyalkyle en $C_2$-$C_4$.

4. Mélange photopolymérisable selon la revendication 1 qui contient comme composante B) un photoinducteur de formule I dans lequel Ar est un radical phényle, sans substituants ou portant à la position 4 un atome de chlore ou un groupe méthyle, méthoxy, méthylthio, di($C_1$-$C_4$-alkyl)amino ou morpholino, $R^1$ et $R^2$ sont chacun un alkyle en $C_1$-$C_4$ et $R^3$ et $R^4$ chacun un alkyle en $C_1$-$C_4$ ou le groupe 2-méthoxyéthyle, ou bien $R^3$ et $R^4$ forment ensemble et avec l'atome d'azote un cycle de morpholine.

5. Mélange photopolymérisable selon la revendication 1 qui contient comme composante C) une thioxanthone.

6. Mélange photopolymérisable selon la revendication 1 qui contient comme composante C) une 3-acylcoumarine.

7. Mélange photopolymérisable selon la revendication 1 qui contient comme composante C) une 2-(aroylméthylène)-thiazoline.

8. Mélange photopolymérisable selon la revendication 1 qui contient comme composante A) un ou plusieurs dérivés de l'acide acrylique.

9. Mélange photopolymérisable selon la revendication 1 qui contient d'autres constituants en plus des composantes A), B) et C).

10. Procédé de photopolymérisation de composés à insaturation éthylénique par irradiation en une lumière à courte longueur d'onde en présence d'un photoinducteur et d'un photosensibilisateur, procédé caractérisé en ce que l'on utilise comme photoinducteur un composé de formule I ou II selon la revendication 1, et comme photosensibilisateur un composé carbonylique aromatique ayant une énergie de triplet de 225 à 276 KJ/mole.

11. Composé de formules I et II :

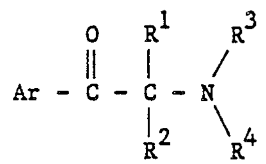

(I)

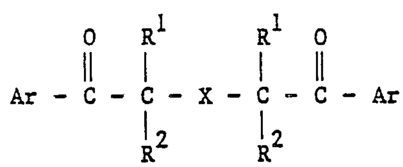

(II)

dans lesquelles Ar représente un radical phényle, biphénylyle ou benzoylphényle avec comme substituants un ou plusieurs atomes d'halogènes ou groupes alkyles en $C_1$-$C_{12}$, alcényles en $C_3$-$C_{12}$, cycloalkyles en $C_5$-$C_6$, phénylalkyles en $C_7$-$C_9$, —COOH, $—COO(C_1$-$C_4$-alkyles), $—OR^5$, méthylène-dioxy, —SH, $—SR^6$, $—SO—R^6$, $—SO_2—R^6$, —CN, $—SO_2NH_2$, $—SO_2NH(C_1$-$C_4$-alkyles), $—SO_2—N(C_1$-$C_4$-alkyles$)_2$, $—N(R^7)(R^8)$, $—NHCO—R^9$ ou encore un groupe de formule :

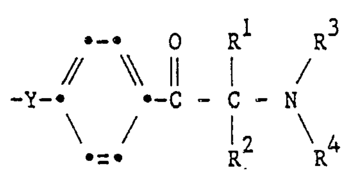

ce radical Ar comprenant au moins un groupe —$N(R^7)$ $(R^8)$,
X désigne un radical divalent de formule

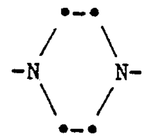

—$N(R^{11})$— ou —$N(R^{11})$—$(CH_2)_m$—$N(R^{11'})$—, m étant un nombre de 1 à 8,

Y désigne une liaison directe ou bien —$CH_2$—, —$CH_2CH_2$—, —O—, —S—, —CO— ou —$N(R^{10})$—,

$R^1$ et $R^2$ représentent chacun, indépendamment l'un de l'autre, un alkyle en $C_1$-$C_8$ ou bien un alkyle en $C_1$-$C_4$ substitué par un groupe OH, alcoxy en $C_1$-$C_4$, —CN, —COO($C_1$-$C_8$-alkyle), ($C_1$-$C_4$-alkyl)—COO— ou —$N(R^3)(R^4)$, un alcényle en $C_3$-$C_6$ ou un groupe phényle, chlorophényle, $R^5$—O—phényle, $R^6$—S—phényle ou phénylalkyle en $C_7$-$C_9$, ou bien $R^1$ et $R^2$ forment ensemble un alkylène en $C_2$-$C_9$, linéaire ou ramifié, ou bien un groupe oxa-alkylène ou aza-alkylène en $C_3$-$C_9$,

$R^3$ et $R^4$ représentent chacun, indépendamment l'un de l'autre, l'hydrogène, un alkyle en $C_1$-$C_{12}$ ou un alkyle en $C_2$-$C_4$ substitué par un ou plusieurs groupes OH, alcoxy en $C_1$-$C_4$, —CN ou —COO($C_1$-$C_4$-alkyles), un alcényle en $C_3$-$C_5$, un cyclohexyle, un phénylalkyle en $C_7$-$C_9$ ou encore un groupe vinyle pouvant être éventuellement substitué par Cl, OH, des groupes alkyles en $C_1$-$C_{12}$, alcoxy en $C_1$-$C_4$ ou —COO($C_1$-$C_4$-alkyles), ou bien $R^3$ et $R^4$ forment ensemble un alkylène en $C_3$-$C_7$ pouvant être interrompu par —O—, —S— ou —$N(R^{12})$—, ou encore $R^4$ forme avec $R^2$ un alkylène en $C_1$-$C_7$, un phénylalkylène en $C_7$-$C_{10}$, un groupe o-xylylène ou un groupe oxa- ou aza-alkylène en $C_1$-$C_3$,

$R^5$ désigne l'hydrogène, un alkyle en $C_1$-$C_{12}$, un alcényle en $C_3$-$C_{12}$, un cyclohexyle, un hydroxycyclohexyle, un alkyle en $C_1$-$C_4$ avec comme substituants un ou plusieurs atomes de chlore ou de brome ou groupes CN, SH, —N($C_1$-$C_4$-alkyles)$_2$, pipéridino, morpholino, OH, —O($C_1$-$C_4$-alkyles), —$OCH_2CH_2CN$, —$OCH_2CH_2COO$($C_1$-$C_4$-alkyles), —OOC—$R^9$, —COOH, —COO($C_1$-$C_8$-alkyles), —CONH($C_1$-$C_4$-alkyles), —CON($C_1$-$C_4$-alkyles)$_2$,

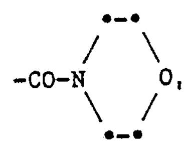

—CO—($C_1$-$C_4$-alkyles) ou —CO—phényles, ou encore un groupe 2,3-époxypropyle, —$(CH_2CH_2O)_n$—H, n étant un nombre de 2 à 20, phényle, phénylalkyle en $C_7$-$C_9$, un phényle halogéné ou substitué par un alkyle en $C_1$-$C_4$, un alcoxy en $C_1$-$C_4$ ou un groupe —COO($C_1$-$C_4$-alkyle), un groupe tétrahydropyrannyle, tétrahydrofurannyle, —CO—$R^9$, —COO($C_1$-$C_8$-alkyle), —CONH($C_1$-$C_4$-alkyle), —CON($C_1$-$C_4$-alkyle)$_2$, —$Si(R^{13})$ $(R^{14})_2$ ou —$SO_2$-$R^{15}$,

$R^6$ désigne un alkyle en $C_1$-$C_{12}$, un alcényle en $C_3$-$C_{12}$, un cyclohexyle, un hydroxycyclohexyle, un alkyle en $C_1$-$C_4$ avec comme substituants un ou plusieurs atomes de chlore ou de brome ou groupes CN, SH, —N($C_1$-$C_4$-alkyles)$_2$, pipéridino, morpholino, —OH, —O($C_1$-$C_4$-alkyles), —$OCH_2CH_2$—CN, —$OCH_2CH_2COO$($C_1$-$C_4$-alkyles), —OOC—$R^9$, —COOH, —COO($C_1$-$C_8$-alkyles, —CON($C_1$-$C_8$-alkyles)$_2$,

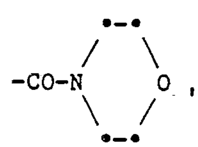

—CO—($C_1$-$C_4$-alkyles) ou —CO—phényles, ou encore un groupe 2,3-époxypropyle, phényle, phénylalkyle en $C_7$-$C_9$, phénylhydroxyalkyle en $C_7$-$C_9$, un phényle substitué par un halogène ou un alkyle en $C_1$-$C_4$, un alcoxy en $C_1$-$C_4$ ou un groupe —COO($C_1$-$C_4$-alkyle), un groupe 2-benzothiazolyle, 2-benzimidazolyle, —$CH_2CH_2$—O—$CH_2CH_2$—SH ou —$CH_2CH_2$—S—$CH_2CH_2$—SH,

$R^7$ et $R^8$ représentent chacun, indépendamment l'un de l'autre, un alkyle en $C_1$-$C_{12}$, ou un alkyle en $C_2$-$C_4$ substitué par un groupe —OH, un alcoxy en $C_1$-$C_4$, un groupe —CN ou —COO($C_1$-$C_4$-alkyle), un alcényle en $C_3$-$C_5$, un cyclohexyle, un phénylalkyle en $C_7$-$C_9$ ou encore un phényle qui peut éventuellement avoir comme substituants un ou plusieurs alkyles en $C_1$-$C_{12}$ ou atomes d'halogènes, ou bien $R^7$ et $R^8$ forment ensemble un alkylène en $C_2$-$C_7$ pouvant être interrompu par —O—, —S— ou un groupe —$N(R^{12})$—,

$R^9$ désigne un alkyle en $C_1$-$C_4$, un alcényle en $C_2$-$C_4$ ou le groupe phényle,

$R^{11}$ et $R^{11'}$ désignent l'hydrogène, des alkyles en $C_1$-$C_9$, des hydroxyalkyles en $C_1$-$C_4$ ou le groupe cyclohexyle ou benzyle,

$R^{12}$ désigne l'hydrogène, un alkyle en $C_1$-$C_4$ ou un groupe allyle, benzyle, hydroxyalkyle en $C_1$-$C_4$, —$CH_2CH_2CN$ ou —$CH_2CH_2$—COO($C_1$-$C_4$-alkyle),

$R^{13}$ et $R^{14}$ sont des alkyles en $C_1$-$C_4$ ou le groupe phényle, et

$R^{15}$ est un alkyle en $C_1$-$C_{18}$, un phényle ou un alkylphényle en $C_7$-$C_{20}$.

12. Un composé selon la revendication 11 dans lequel Ar est un groupe phényle, alkylphényle ou halogénophényle ayant comme substituant un radical —N($R^7$)($R^8$).

13. Un composé selon la revendication 11 dans lequel Ar est un groupe phényle portant comme substituant un groupe —N($R^7$)($R^8$).

14. Un composé selon la revendication 11 dans lequel Ar est groupe phényle avec à la position 4 un groupe dialkylamino, di(alcoxyalkyl)amino, morpholino, pipéridino ou 4-méthylpipérazino.

15. La 2-méthyl-1-(4-diméthylaminophényl)-2-diméthylamino-propanone-1 selon la revendication 11.

16. L'utilisation des composés de la revendication 11 comme photoinducteurs pour la photopolymérisation de composés à insaturation éthylénique.

17. Mélange photopolymérisable selon la revendication 1 qui contient comme composante B) un composé de la revendication 11.